Europäisches Patentamt

(19) European Patent Office

Office européen des brevets

(11) **EP 0 919 989 A1**

## (12) EUROPEAN PATENT APPLICATION
published in accordance with Art. 158(3) EPC

(43) Date of publication:
02.06.1999 Bulletin 1999/22

(21) Application number: 98919600.1

(22) Date of filing: 14.05.1998

(51) Int. Cl.$^6$: **G10L 9/18**, H03M 7/30

(86) International application number:
PCT/JP98/02135

(87) International publication number:
WO 98/52188 (19.11.1998 Gazette 1998/46)

(84) Designated Contracting States:
DE ES FR GB IT

(30) Priority: 15.05.1997 JP 125844/97
13.03.1998 JP 62413/98

(71) Applicant:
MATSUSHITA ELECTRIC INDUSTRIAL CO., LTD.
Kadoma-shi, Osaka 571-8501 (JP)

(72) Inventors:
• TSUSHIMA, Mineo
Osaka 576-0021 (JP)
• NORIMATSU, Takeshi
Kobe-shi, Hyogo 651-1301 (JP)
• ISHIKAWA, Tomokazu
Osaka 561-0828 (JP)

(74) Representative:
Eisenführ, Speiser & Partner
Martinistrasse 24
28195 Bremen (DE)

(54) **AUDIO SIGNAL ENCODER, AUDIO SIGNAL DECODER, AND METHOD FOR ENCODING AND DECODING AUDIO SIGNAL**

(57) With respect to audio signal coding and decoding apparatuses, there is provided a coding apparatus that enables a decoding apparatus to reproduce an audio signal even through it does not use all of data from the coding apparatus, and a decoding apparatus corresponding to the coding apparatus.

A quantization unit constituting a coding apparatus 1 comprises: a first sub-quantization unit 501 comprising sub-quantization units for low-band, intermediate-band, and high-band; a second sub-quantization unit 502 for quantizing quantization errors from the first sub-quantization unit 501; and a third sub-quantization unit 503 for quantizing quantization errors which have been processed by the first sub-quantization unit 501 and the second sub-quantization unit 502.

Fig.4

EP 0 919 989 A1

## Description

Technical Field

The present invention relates to an audio signal coding apparatus for coding an audio signal, such as a voice signal or a music signal and, more particularly, to an apparatus for transforming an audio signal from time-domain to frequency-domain using a method like orthogonal transformation, and efficiently coding the transformed signal so that it is expressed with less code streams as compared with the original audio signal, and to a decoding apparatus having a structure capable of decoding a high-quality and broad-band audio signal using all or only a portion of the coded streams which are coded signals. Furthermore, the invention relates to an audio signal coding and decoding method.

Background Art

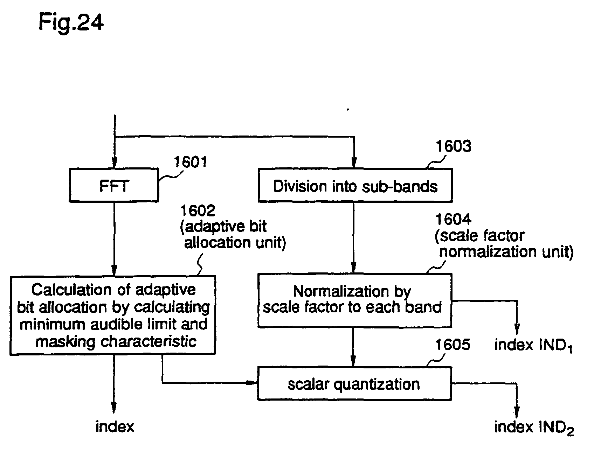

Various methods for efficiently coding and decoding audio signals have been proposed. Especially for an audio signal having a frequency band exceeding 20kHz such as a music signal, an MPEG audio method has been proposed in recent years. In the coding method represented by the MPEG method, a digital audio signal on the time axis is transformed to data on the frequency axis using orthogonal transform such as cosine transform, and data on the frequency axis are coded from auditively important one by using the auditive sensitivity characteristic of human beings, whereas auditively unimportant data and redundant data are not coded. In order to express an audio signal with a data quantity considerably smaller than the data quantity of the original digital signal, there is a coding method using a vector quantization method, such as TC-WVQ. The MPEG audio and the TC-WVQ are described in "ISO/IEC standard IS-11172-3" and "T.Moriya, H.Suga: An 8 Kbits transform coder for noisy channels, Proc. ICASSP 89, pp.196-199", respectively. Hereinafter, the structure of a conventional audio coding apparatus will be explained using figure 24. In figure 24, reference numeral 1601 denotes an FFT unit which frequency-transforms an input signal; 1602 denotes an adaptive bit allocation calculating unit which performs calculation of adaptive bit allocation by calculating a minimum audible limit and masking characteristic so that a specific band of the frequency-transformed input signal is coded; 1603 denotes a subband division unit which divides the input signal into plural bands; 1604 denotes a scale factor normalization unit which normalizes each component of the band divided in plural, using a scale factor; and 1605 denotes a scalar quantization unit which performs scalar quantization of the normalized output from the scale factor normalization unit 1604, according to the bit allocation from the adaptive bit allocation calculating unit 1602.

A description is given of the operation. An input signal is input to the FFT unit 1601 and the sub-band division unit 1603. In the FFT unit 1601, the input signal is subjected to frequency conversion, and the output is input to the adaptive bit allocation unit 1602. In the adaptive bit allocation unit 1602, how much data quantity is to be given to a specific band component is calculated on the basis of the minimum audible limit, which is defined according to the auditive characteristic of human beings, and the masking characteristic, and the data quantity allocation for each band is coded as an index.

On the other hand, in the sub-band division unit 1603, the input signal is divided into, for example, 32 bands, to be output. In the scale factor normalization unit 1604, for each band component obtained in the sub-band division unit 1603, normalization is carried out with a representative value. The normalized value is quantized as an index. In the scalar quantization unit 1605, on the basis of the bit allocation calculated by the adaptive bit allocation calculating unit 1602, the output from the scale factor normalization unit 1604 is scalar-quantized, and the quantized value is coded as an index IND2.

In the conventional audio signal coding apparatus constructed as described above, it is general that the MPEG audio method is used so that coding is carried out with a data quantity of 64000 bits/sec for each channel. With a data quantity smaller than this, the reproducible frequency band width and the subjective quality of decoded audio signal are sometimes degraded considerably. The reason is as follows. As in the example shown in figure 37, the coded data are divided into three main parts, i.e., the bit allocation obtained by the adaptive bit allocation unit 1602, the band representative value obtained by the scale factor normalization unit 1604, and the quantized value obtained by the scalar quantization unit 1605. So, when the compression ratio is high, a sufficient data quantity is not allocated to the quantized value. Further, in the conventional audio signal coding apparatus, it is general that a coder and a decoder are constructed with the data quantity to be coded and the data quantity to be decoded being equal to each other. For example, in a method where a data quantity of 128000 bits/sec is coded, a data quantity of 128000 bits is decoded in the decoder.

However, in the conventional audio signal coding and decoding apparatuses, coding and decoding must be carried out with a fixed data quantity to obtain a satisfactory sound quality and, therefore, it is impossible to obtain a high-quality sound at a high compression ratio.

The present invention is made to solve the above-mentioned problems and has for its object to provide audio signal coding and decoding apparatuses and an audio signal coding and decoding method, in which a high quality and a broad reproduction frequency band are obtained even when coding and decoding are carried out with a small data quantity and, further, the data quantity in the coding and decoding can be variable, not fixed.

Furthermore, the present invention has for its object to provide audio signal coding and decoding apparatuses, and an audio signal coding and decoding method, that can significantly improve the quantization efficiency.

Disclosure of the Invention

In order to solve the above-described problems, according to the invention of Claim 1, there is provided an audio signal coding apparatus for coding an audio signal by performing vector quantization to a frequency characteristic signal sequence which is obtained by subjecting an input audio signal to frequency transformation, and the apparatus comprises: multiple-stage quantization means comprising, at least, a first-stage vector quantizer for vector-quantizing the frequency characteristic signal sequence or a portion thereof, and a second-stage vector quantizer for vector-quantizing a quantization error component generated by the first-stage vector quantizer; and each quantization means in each stage of the multiple-stage quantization means having at least one divided vector quantizer which vector-quantizes a coefficient stream in any of plural frequency bands obtained by dividing the frequency characteristic signal sequence into, at least, two frequency bands which can have an overlapped portion between the plural stages, using a division manner for each stage.

According to the invention of Claim 2, the audio signal coding apparatus defined in Claim 1 further comprises a normalization means for normalizing the frequency characteristic signal sequence, and adding its output to the multiple-stage quantization means.

According to the invention of Claim 3, in the audio signal coding apparatus defined in any of Claims 1 and 2, the quantization means in each stage appropriately selects, as a frequency band divided from the frequency characteristic signal sequence to be quantized, a band having a large energy-addition-sum of the quantization error, and quantizes the selected band.

According to the invention of Claim 4, in the audio signal coding apparatus defined in any of Claims 1 and 2, the quantization means in each stage selects a frequency band, as a frequency band divided from the frequency characteristic signal sequence to be quantized, on the basis of the auditive sensitivity characteristic showing the auditive nature of human beings, and quantizes the selected band, which frequency band selected has a large energy-addition-sum of a quantization error weighted by giving a large value to a band having a high importance of the auditive sensitivity characteristic.

According to the invention of Claim 5, the audio signal coding apparatus defined in any of Claims 1 to 4 further comprises: a first quantization band selection unit between the first-stage vector quantizer and the second-stage vector quantizer which are constituents of the multiple-stage quantization means; and a second quantization band selection unit between the second-stage vector quantizer and the third-stage vector quantizer; wherein the first quantization band selection unit receives, as an input, the quantization error output from the first-stage vector quantizer, and selects a band to be quantized by the second-stage vector quantizer; and the second quantization band selection means receives, as an input, the quantization error output from the second-stage vector quantizer, and selects a band to be quantized by the third-stage vector quantizer.

According to the invention of Claim 6, in the audio signal coding apparatus defined in Claim 5, the multiple-stage quantization means comprises: a plurality of i-th stage divided vector quantizers which quantize, independently, the respective coefficient streams in the respective frequency bands into which the frequency characteristic signal sequence is divided; and a j-th stage vector quantizer which serves as an entire-band quantizer for quantizing, once at least, all of the respective frequency bands of the input signal to be quantized.

According to the invention of Claim 7, in the audio signal coding apparatus defined in Claim 1, in the multiple-stage quantization means, the previous-stage vector quantizer calculates a quantization error in vector quantization using a vector quantization method with a code book, and the subsequent-stage vector quantizer performs further vector quantization to the calculated quantization error.

According to the invention of Claim 8, in the audio signal coding apparatus defined in Claim 2, in the multiple-stage quantization means, the previous-stage vector quantizer calculates a quantization error in vector quantization using a vector quantization method with a code book, and the subsequent-stage vector quantizer performs further vector quantization to the calculated quantization error.

According to the invention of Claim 9, in the audio signal coding apparatus defined in Claim 8, when calculating distances between codes used for retrieving an optimum code in the code book during vector quantization, the vector quantizer in the multiple-stage quantization means calculates the distances using, as weights, normalized components of the input signal output from the normalization means, and extracts a code having a minimum distance.

According to the invention of Claim 10, in the audio signal coding apparatus defined Claim 9, the vector quantizer in the multiple-stage quantization means calculates the distances using, as weights, both of the normalized component of the frequency characteristic signal sequence output from the normalization means and a value in view of the auditive characteristic showing the auditive nature of human beings, and extracts a code having a minimum distance.

According to the invention of Claim 11, in the audio signal coding apparatus defined in any of Claims 2 and 8~10, the normalization means is provided with a frequency outline normalization unit which roughly normalizes the outline of the frequency characteristic signal sequence.

According to the invention of Claim 12, in the audio signal coding apparatus defined in any of Claims 2 and 8~10, the normalization means is provided with a band amplitude normalization unit which divides the frequency characteristic signal sequence into a plurality of components of continuous unit frequency bands, and normalizes the coefficient stream in each unit band by dividing it with a single value.

According to the invention of Claim 13, in the audio signal coding apparatus defined in Claim 1, the multiple-stage quantization means comprises: a vector quantizer which quantizes the respective coefficient streams of the respective frequency bands into which the frequency characteristic signal sequence is divided, independently by divided vector quantizers; and a vector quantizer which serves as an entire-band quantizer for quantizing, once at least, all of the respective frequency bands of the input signal to be quantized.

According to the invention of Claim 14, in the audio signal coding apparatus defined in Claim 13, the multiple-stage quantization means comprises: a first vector quantizer comprising a low-band divided vector quantizer, an intermediate-band divided vector quantizer, and a high-band divided vector quantizer; a second vector quantizer connected after the first vector quantizer; and a third vector quantizer connected after the second vector quantizer; wherein a frequency characteristic signal sequence input to the multiple-stage quantization means is divided into three bands, and the frequency characteristic signal sequence of low-band component among the three bands is quantized by the low-band divided vector quantizer, the frequency characteristic signal sequence of intermediate-band component among the three bands is quantized by the intermediate-band divided vector quantizer, and the frequency characteristic signal sequence of high-band component among the three bands is quantized by the high-band divided vector quantizer, independently; each of the divided vector quantizers constituting the first vector quantizer calculates a quantization error with respect to the frequency characteristic signal sequence, and outputs this error toward the subsequent second vector quantizer; the second vector quantizer performs quantization for a band width to be quantized by the second vector quantizer, calculates a quantization error with respect to the input to the second vector quantizer, and outputs this error toward the third vector quantizer; and the third vector quantizer performs quantization for a band width to be quantized by the third vector quantizer.

According to the invention of Claim 15, the audio signal coding apparatus defined in Claim 14 further comprises a first quantization band selection unit disposed between the first vector quantizer and the second vector quantizer which are constituents of the multiple-stage quantization means, and a second quantization band selection unit disposed between the second vector quantizer and the third vector quantizer; wherein the first quantization band selection unit receives, as an input, the output from the first vector quantizer, and selects a band to be quantized by the second vector quantizer; the second vector quantizer performs quantization for a band width to be quantized by the second vector quantizer, with respect to the quantization errors from the first vector quantizer comprising the three vector quantizers, in the band selected by the first quantization band selection unit, calculates a quantization error with respect to the input to the second vector quantizer, and outputs this error toward the second quantization band selection unit; the second quantization band selection unit receives, as an input, the quantization error from the second vector quantizer, and selects a band to be quantized by the third vector quantizer; and the third vector quantizer performs quantization for a band width to be quantized by the third vector quantizer, with respect to the quantization error from the second vector quantizer in the band selected by the second quantization band selection unit.

According to the invention of Claim 16, in the audio signal coding apparatus defined in Claim 14, in place of the first vector quantizer, the second vector quantizer or the third vector quantizer is constructed using the low-band divided vector quantizer, the intermediate-band divided vector quantizer, and the high-band divided vector quantizer.

According to the invention of Claim 17, there is provided an audio signal decoding apparatus receiving, as an input, codes output from the audio signal coding apparatus defined in Claim 1, and decoding these codes to output a signal corresponding to the original input audio signal, and the decoding apparatus comprises: an inverse quantization unit for performing inverse quantization using at least a portion of the codes output from the quantization means of the audio signal coding apparatus; and an inverse frequency transformation unit for transforming a frequency characteristic signal sequence output from the inverse quantization unit to a signal corresponding to the original audio input signal.

According to the invention of Claim 18, there is provided an audio signal decoding apparatus receiving, as an input, codes output from the audio signal coding apparatus defined in Claim 2, and decoding these codes to output a signal corresponding to the original input audio signal, and the decoding apparatus comprises: an inverse quantization unit for reproducing a frequency characteristic signal sequence; an inverse normalization unit for reproducing normalized components on the basis of the codes output from the audio signal coding apparatus, using the frequency characteristic signal sequence output from the inverse quantization unit, and multiplying the frequency characteristic signal sequence and the normalized components; and an inverse frequency transformation unit for receiving the output from the inverse normalization unit and transforming the frequency characteristic signal to a signal corresponding to the original audio signal.

According to the invention of Claim 19, there is provided an audio signal decoding apparatus receiving, as an input, codes output from the audio signal coding apparatus defined in Claim 13, and decoding these codes to output a signal corresponding to the original input audio signal, and the decoding apparatus comprises: an inverse quantization unit which performs inverse quantization using the output codes whether the codes are output from all of the vector quantizers constituting the quantization means in the audio signal coding apparatus, or from some of them.

According to the invention of Claim 20, in the audio signal decoding apparatus defined in Claim 19, subsequent to inverse quantization of quantized codes in a prescribed band in a specific stage, the inverse quantization unit executes, alternately, inverse quantization of quantized codes in the prescribed band in a next stage, and inverse quantization of quantized codes in a band different from the prescribed band in the specific stage; when there are no quantized codes in the prescribed band in the next stage, the inverse quantization unit continuously executes inverse quantization of quantized codes in another different band; and when there are no quantized codes in the band different from the prescribed band, the inverse quantization unit continuously executes inverse quantization of quantized codes in a next stage.

According to the invention of Claim 21, there is provided an audio signal decoding apparatus receiving, as an input, codes output from the audio signal coding apparatus defined in Claim 14, and decoding these codes to output a signal corresponding to the original input audio signal, and the decoding apparatus comprises: an inverse quantization unit which performs inverse quantization using only codes output from the low-band divided vector quantizer as a constituent of the first vector quantizer even though all or some of the three divided vector quantizers constituting the first vector quantizer in the audio signal coding apparatus output codes.

According to the invention of Claim 22, in the audio signal decoding apparatus defined in Claim 21, the inverse quantization unit performs inverse quantization using codes output from the second vector quantizer, in addition to the codes output from the low-band divided vector quantizer as a constituent of the first vector quantizer.

According to the invention of Claim 23, in the audio signal decoding apparatus defined in Claim 22, the inverse quantization unit performs inverse quantization using codes output from the intermediate-band divided vector quantizer as a constituent of the first vector quantizer, in addition to the codes output from the low-band divided vector quantizer as a constituent of the first vector quantizer and the codes output from the second vector quantizer.

According to the invention of Claim 24, in the audio signal decoding apparatus defined in Claim 23, the inverse quantization unit performs inverse quantization using codes output from the third vector quantizer, in addition to the codes output from the low-band divided vector quantizer as a constituent of the first vector quantizer, the codes output from the second vector quantizer, and the codes output from the intermediate-band divided vector quantizer as a constituent of the first vector quantizer.

According to the invention of Claim 25, in the audio signal decoding apparatus defined in Claim 24, the inverse quantization unit performs inverse quantization using codes output from the high-band divided vector quantizer as a constituent of the first vector quantizer, in addition to the codes output from the low-band divided vector quantizer as a constituent of the first vector quantizer, the codes output from the second vector quantizer, the codes output from the intermediate-band divided vector quantizer as a constituent of the first vector quantizer, and the codes output from the third vector quantizer.

According to the invention of Claim 26, there is provided an audio signal coding and decoding method receiving a frequency characteristic signal sequence obtained by frequency transformation of an input audio signal, coding and outputting this signal, and decoding the output coded signal to reproduce a signal corresponding to the original input audio signal, wherein: the frequency characteristic signal sequence is divided into coefficient streams corresponding to at least two frequency bands, and these coefficient streams are independently quantized and output; and from the quantized signal received, data of an arbitrary band corresponding to the divided band are inversely quantized, thereby to reproduce a signal corresponding to the original input audio signal.

According to the invention of Claim 27, in the audio signal coding and decoding method defined in Claim 26, the quantization is performed by stages so that a calculated quantization error is further quantized; and the inverse quantization is performed by repeating, alternately, quantization directed at expanding the band, and quantization directed at deepening the quantization stages at the quantization.

According to the invention of Claim 28, in the audio signal coding and decoding method defined in Claim 27, the inverse quantization directed at expanding the band is carried out by extending the band in the order with regard to the auditive psychological characteristic of human beings.

According to the invention of Claim 29, in the audio signal coding and decoding method defined in any of Claims 26 to 28, at the coding end, after the frequency characteristic signal sequence is normalized, the frequency characteristic signal sequence is divided into coefficient streams corresponding to at least two frequency bands, and the respective coefficient streams are independently quantized and output; and at the decoding end, using the codes relating to normalization from the coding end, the codes from the coding end is subjected to inverse normalization and, thereafter, the inversely normalized codes are subjected to inverse quantization so that data in an arbitrary band corresponding to the divided band are inversely quantized, thereby to reproduce a signal corresponding to the original audio input signal.

According to the invention of Claim 30, there is provided an audio signal coding apparatus for coding an audio signal by performing normalization and vector quantization to a frequency characteristic signal sequence which is obtained by subjecting an input audio signal to frequency transformation, and the apparatus comprises: multiple-stage quantization means comprising, at least, a first-stage normalization and vector-quantization unit which normalizes and vector-quantizes the frequency characteristic signal sequence or a portion thereof, and a second-stage normalization and vector-quantization unit which normalizes and vector-quantizes a quantization error component generated by the first-stage vector-quantization unit; and each quantization means in each stage of the multiple-stage quantization means having at least one divided normalization and vector-quantization unit which normalizes and vector-quantizes a coefficient stream of any of plural frequency bands obtained by dividing the frequency characteristic signal sequence into, at least, two frequency bands which can have an overlapped portion between the plural stages, using a division manner for each stage.

According to the invention of Claim 31, the audio signal coding apparatus defined in Claim 30 further comprises: a first quantization band selection unit between the first-stage normalization and vector-quantization unit and the second-stage normalization and vector-quantization unit which are constituents of the multiple-stage quantization means; and a second quantization band selection unit between the second-stage normalization and vector-quantization unit and a third-stage normalization and vector-quantization unit; wherein the first quantization band selection unit receives, as an input, the quantization error output from the first-stage normalization and vector-quantization unit, selects a band to be quantized by the second-stage normalization and vector-quantization unit, and outputs a quantization error in the selected band toward the second-stage normalization and vector-quantization unit; and the second quantization band selection means receives, as an input, the quantization error output from the second-stage normalization and vector-quantization unit, selects a band to be quantized by the third-stage normalization and vector-quantization unit, and outputs a quantization error in the selected band toward the third-stage normalization and vector-quantization unit.

According to the invention of Claim 32, in the audio signal coding apparatus defined in Claim 31, each of the normalization and vector-quantization units in and after the second stage of the multiple-stage quantization means appropriately selects a frequency band having a large energy-addition-sum of the quantization error output from the previous-stage normalization and vector-quantization unit, from the frequency bands divided from the frequency characteristic signal sequence to be normalized and quantized, and then the unit normalizes and quantizes the selected band.

According to the invention of Claim 33, in the audio signal coding apparatus defined in Claim 31, each of the normalization and vector-quantization units in and after the second stage of the multiple-stage quantization means appropriately selects a frequency band from the frequency bands divided from the frequency characteristic signal sequence to be normalized and quantized, on the basis of the auditive sensitivity characteristic showing the auditive nature of human beings, which frequency band selected has a large energy-addition-sum of the quantization error that is output from the previous-stage normalization and vector-quantization unit and weighted by giving a large value to a band having a high importance of the auditive sensitivity characteristic, and then the unit normalizes and quantizes the selected band.

According to the invention of Claim 34, there is provided an audio signal decoding apparatus receiving, as an input, codes output from an audio signal coding apparatus as defined in any of Claims 30 to 33, and decoding the codes to output a signal corresponding to the original input audio signal, and the decoding apparatus comprises: inverse quantization units for receiving signals from the respective quantizers of the quantization unit in the audio signal coding apparatus, and reproducing signals corresponding to the coefficient streams of the respective frequency bands into which the frequency characteristic signal sequence is divided; a plurality of inverse normalization units provided correspondingly to the respective inverse quantization units, for multiplying the coefficient streams of the frequency characteristic signal sequence output from the respective inverse quantization units by normalized components reproduced on the basis of the codes relating to normalization and output from the audio signal coding apparatus, and outputting signals corresponding to the respective coefficient streams of the frequency characteristic signal sequence before being coded; and an inverse frequency transformation unit for receiving the outputs from the plural inverse normalization units, and transforming them to a signal corresponding to the original audio signal.

According to the invention of Claim 35, there is provided an audio signal coding and decoding method receiving a frequency characteristic signal sequence obtained by frequency transformation of an input audio signal, coding and outputting this signal, and decoding the output coded signal to reproduce a signal corresponding to the original input audio signal, wherein: the frequency characteristic signal sequence is divided into coefficient streams corresponding to at least two frequency bands, and these coefficient streams are independently normalized, quantized, and output; and, from the quantized signal received, using the codes relating to normalization and output from the coding end, data of an arbitrary band corresponding to the divided band are inversely normalized and quantized, thereby to reproduce a signal corresponding to the original input audio signal.

According to the invention of Claim 36, in the audio signal coding and decoding method defined in Claim 35, the normalization and quantization are carried out by stages so that the calculated quantization errors are further normalized and quantized; and the inverse normalization and quantization are carried out by repeating, alternately, inverse normalization and quantization directed at extending the band, and inverse normalization and quantization directed at deepening the quantization stages at the quantization.

According to the invention of Claim 37, in the audio signal coding and decoding method defined in Claim 36, the inverse normalization and quantization directed at extending the band is performed by extending the band in the order in view of the auditive psychological characteristic of human beings.

According to the invention of Claim 38, there is provided an audio signal coding apparatus for coding an audio signal by performing vector quantization to a frequency characteristic signal sequence which is obtained by subjecting an input audio signal to frequency transformation, and the apparatus comprises: multiple-stage quantization means comprising, at least, a first-stage vector quantizer for vector-quantizing the frequency characteristic signal sequence, and a second-stage vector quantizer for vector-quantizing a quantization error component generated by the first-stage vector quantizer; and each quantization means in each stage of the multiple-stage quantization means comprising an entire-band vector quantizer for vector-quantizing all of the frequency characteristic signal sequence or all of the quantization error components output from the previous-stage quantization means.

As described above, according to the audio signal coding apparatus, and decoding apparatus, or coding and decoding method of the present invention, provided for quantization is a structure capable of performing quantization even at a high data compression ratio by using, for example, a vector quantization method, and employed for allocation of data quantity during quantization is to allocate, alternately, data quantity contributing to expansion of a reproduced band and data quantity contributing to improvement of quality. First of all, in the coding apparatus, as the first stage, an input audio signal is transformed to a signal in the frequency domain, and a portion of the frequency signal is coded; in the second stage, a portion of the frequency signal uncoded and a quantization error signal in the first stage are coded and added to the codes obtained in the first stage; in the third stage, the other portion of the frequency signal uncoded, and quantization error signals in the first and second stages are coded and added to the codes obtained in the first and second stages; followed by similar coding in forward stages. On the other hand, in the decoding apparatus, any of the following decoding manners is possible: decoding using only the codes coded in the first stage, decoding using the codes decoded in the first and second stages, and decoding using the codes decoded in stages from the first stage to the third or more stage. The decoding order is to decode, alternately, codes contributing to band expansion and codes contributing to quality improvement. Therefore, satisfactory sound quality is obtained even though coding and decoding are carried out without a fixed data quantity. Further, a high-quality sound is obtained at a high compression ratio.

Furthermore, according to the audio signal coding apparatus, and decoding apparatus, or coding and decoding method of the present invention, a normalization means is provided before the quantization means, and normalization of an input audio signal is carried out before quantization. Therefore, the normalization means and the quantization means perform coding while exhibiting their full abilities, whereby highly efficient quantization is carried out without losing the data quantity possessed by the original audio signal and, therefore, with less quantization error, and the effect is dramatically heightened according to the kind of the audio signal. Furthermore, as described above, allocation of data quantity during quantization is carried out so as to allocate, alternately, data quantity contributing to expansion of a reproduced band and data quantity contributing to improvement of quality. When the data quantity at the receiving end is limited, inverse quantization is carried out only in a narrow band and a shallow region. However, by expanding the inverse quantization alternately in the direction to broaden the band and the direction to increase the depth of the inverse quantization to increase the data quantity at the receiving end, a desired quantity of data of the coded audio signal can be decoded regardless of the quantity of data transmitted from the coding apparatus. Accordingly, by varying the quantity of data to be decoded according to the communication environment or the like on the receiving end, high-definition sound quality can be obtained stably even when an ordinary public telephone network is used.

Furthermore, according to the audio signal coding apparatus, and decoding apparatus, or coding and decoding method of the present invention, a normalization means is provided before each of quantization means performing multiple-stage quantization, and normalization is performed for each of divided frequencies and for each stage of quantization, followed by quantization. Therefore, normalization for each frequency domain enables appropriate coding according to the quantity of data possessed by the audio signal in each frequency domain, that is, the normalization means and the quantization means perform coding while exhibiting their full abilities, whereby quantization of high efficiency is performed without losing the data quantity possessed by the original audio signal and, therefore, with less quantization error, with the result that high-definition sound quality is obtained stably, and the effect is dramatically heightened according to the kind of the audio signal. Further, at the decoding end, when inverse normalization and inverse quantization are carried out in both of the direction to broaden the quantization band and the direction to increase the quantization depth, alternately, a desired quantity of data of the coded audio signal can be decoded regardless of the quantity of data transmitted from the coding apparatus. Accordingly, by varying the quantity of data to be decoded according to the communication environment or the like on the receiving end, high-definition sound quality can be obtained stably even when an ordinary public telephone network is used.

Brief Description of the Drawings

Figure 1 is a diagram illustrating the entire structure of audio signal coding and decoding apparatuses according to a first embodiment of the present invention.

Figure 2 is a block diagram illustrating an example of a normalization unit as a constituent of the above-described audio signal coding apparatus.

Figure 3 is a block diagram illustrating an example of a frequency outline normalization unit as a constituent of the above-described audio signal coding apparatus.

Figure 4 is a block diagram illustrating a quantization unit as a constituent of the above-described audio signal coding apparatus, according to a first embodiment of the present invention.

Figure 5 is a block diagram illustrating a quantization unit as a constituent of the above-described audio signal coding apparatus, according to a second embodiment of the present invention.

Figure 6 is a block diagram illustrating a quantization unit as a constituent of the above-described audio signal coding apparatus, according to a third embodiment of the present invention.

Figure 7 is a block diagram illustrating an inverse quantization unit as a constituent of the above-described audio signal decoding apparatus, according to a fourth embodiment of the present invention.

Figure 8 is a block diagram illustrating an example of an inverse quantization unit as a constituent of the above-described audio signal decoding apparatus, according to the fourth embodiment of the present invention.

Figure 9 is a block diagram illustrating another example of an inverse quantization unit as a constituent of the above-described audio signal decoding apparatus, according to the fourth embodiment of the present invention.

Figure 10 is a block diagram illustrating still another example of an inverse quantization unit as a constituent of the above-described audio signal decoding apparatus, according to the fourth embodiment of the present invention.

Figure 11 is a block diagram illustrating a further example of an inverse quantization unit as a constituent of the above-described audio signal decoding apparatus, according to the fourth embodiment of the present invention.

Figure 12 is a block diagram illustrating an embodiment of an inverse normalization unit.

Figure 13 is a diagram for explaining the detailed operation of the quantization unit in the coding apparatus.

Figure 14 is a diagram for explaining the detailed operation of the inverse quantization unit in the decoding apparatus.

Figure 15 is a diagram for explaining the operation of the inverse quantization procedure by the inverse quantization unit according to the fourth embodiment.

Figure 16 is a block diagram illustrating an embodiment of a frequency outline inverse quantization unit.

Figure 17 is a diagram for explaining a quantization method employed in the audio signal coding apparatus according to the prior art and the present invention.

Figure 18 is a block diagram illustrating a quantization unit in an audio signal coding apparatus according to a fifth embodiment of the present invention.

Figure 19 is a waveform diagram for explaining the entire operation of the audio signal coding apparatus according to the fifth embodiment of the present invention.

Figure 20 is a diagram illustrating the outline structures of the audio signal coding apparatuses according to the first to third embodiments (20(a)) and the fifth embodiment (20(b),(c)) of the present invention.

Figure 21 is a waveform diagram for explaining the entire operation of the audio signal coding apparatus according to the fifth embodiment of the present invention.

Figure 22 is a diagram for explaining an example of normalization and quantization method by the first-stage to third-stage normalization and quantization means in the audio signal coding apparatus according to the fifth embodiment of the present invention.

Figure 23 is a diagram for explaining the structure of an audio signal decoding apparatus corresponding to the audio signal coding apparatus according to the fifth embodiment of the present invention.

Figure 24 is a diagram illustrating the structure of the conventional audio signal coding apparatus.

Best Modes to Execute the Invention

Hereinafter, embodiments of the present invention will be described using drawings.

**Embodiment 1**

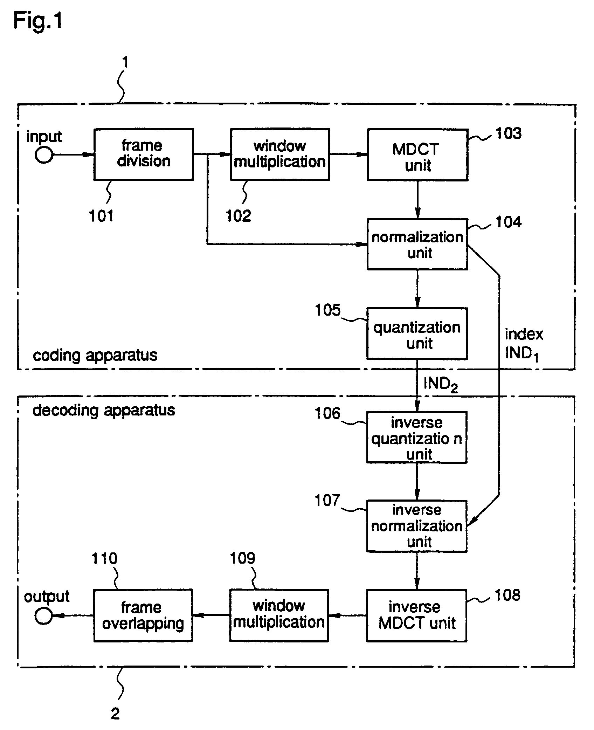

Figure 1 is a diagram illustrating the entire structure of audio signal coding and decoding apparatuses according to a first embodiment of the invention. In figure 1, reference numeral 1 denotes a coding apparatus, and 2 denotes a decoding apparatus. In the coding apparatus 1, reference numeral 101 denotes a frame division unit that divides an input signal into a prescribed number of frames; 102 denotes a window multiplication unit that multiplies the input signal and a window function on the time axis; 103 denotes an MDCT unit that performs modified discrete cosine transform; 104 denotes a normalization unit that receives both of the time axis signal output from the frame division unit 101 and the MDCT coefficients output from the MDCT unit 103 and normalizes the MDCT coefficients; and 105 denotes a quantization unit that receives the normalized MDCT coefficients and quantizes them. Although the MDCT is employed for time-to-frequency transform in this embodiment, discrete Fourier transform (DFT) may be employed.

In the decoding apparatus 2, reference numeral 106 denotes an inverse quantization unit that receives a signal (index IND2) output from the coding apparatus 1 and inversely quantizes this signal; 107 denotes an inverse normalization unit that inversely normalizes the output from the inverse quantization unit 106 using an index IND1 from the normalization unit 104 of the coding apparatus 1; 108 denotes an inverse MDCT unit that performs modified discrete cosine transform to the output from the inverse normalization unit 107; 109 denotes a window multiplication unit that performs window multiplication to the output from the inverse MDCT unit 108; and 110 denotes a frame overlapping unit that performs frame overlapping to the output from the window multiplication unit 110.

A description is given of the operation of the audio signal coding and decoding apparatuses constructed as described above.

It is assumed that the signal input to the coding apparatus 1 is a digital signal sequence that is temporally continuous. For example, it is a digital signal obtained by quantizing an audio signal to 16 bits at a sampling frequency of 48kHz. This input signal is accumulated in the frame division unit 101 until reaching a prescribed sample number, and it is output when the accumulated sample number reaches a defined frame length. Here, the frame length of the frame division unit 101 is, for example, any of 128, 256, 512, 1024, 2048, and 4096 samples. In the frame division unit 101, it is also possible to output the signal with the frame length being variable according to the feature of the input signal. Further, the frame division unit 101 is constructed to perform an output for each shift length specified. For example, in the case where the frame length is 4096 samples, when a shift length half as long as the frame length is set, the frame division unit 101 outputs latest 4096 samples every time the frame length reaches 2048 samples. Of course, even when the frame length or the sampling frequency varies, it is possible to have the structure in which the shift length is set at half of the frame length.

The output from the frame division unit 101 is input to the window multiplication unit 102 and to the normalization unit 104. In the window multiplication unit 102, the output signal from the frame division unit 101 is multiplied by a window function on the time axis, and the result is output from the window multiplication unit 102. This manner is shown by, for example, formula (1).

$$hxi = hi \cdot xi \qquad i = 1,2,..., N \qquad\qquad (1)$$

$$hi = \sin\left(\frac{\pi}{N}(i+0.5)\right)$$

where xi is the output from the frame division unit 101, hi is the window function, and hxi is the output from the window multiplication unit 102. Further, i is the suffix of time. The window function hi shown in formula (1) is an example, and the window function is not restricted to that shown in formula (1). Selection of a window function depends on the feature of the signal input to the window multiplication unit 102, the frame length of the frame division unit 101, and the shapes of window functions in frames which are located temporally before and after the frame being processed. For example, assuming that the frame length of the frame division unit 101 is N, as the feature of the signal input to the window multiplication unit 102, the average power of signals input at every N/4 is calculated and, when the average power varies significantly, the calculation shown in formula (1) is executed with a frame length shorter than N. Further, it is desirable to appropriately select the window function, according to the shape of the window function of the previous frame and the shape of the window function of the subsequent frame, so that the shape of the window function of the present frame is not distorted.

Next, the output from the window multiplication unit 102 is input to the MDCT unit 103, wherein modified discrete cosine transform is executed, and MDCT coefficients are output. A general formula of modified discrete cosine transform is represented by formula (2).

$$yk = \sum_{n=0}^{N-1} hx_n \cdot \cos\left(\frac{2\pi(k+1/2)(n+n_0)}{N}\right) \qquad (2)$$

$$n_0 = N/4+1/2 \qquad (k = 0,1,..., N/2-1)$$

Assuming that the MDCT coefficients output from the MDCT unit 103 are expressed by yk in formula (2), the output from the MDCT unit 103 shows the frequency characteristics, and it linearly corresponds to a lower frequency component as the variable k of yk approaches closer 0, while it corresponds to a higher frequency component as the variable k approaches closer N/2-1 from 0. The normalization unit 104 receives both of the time axis signal xi output from the frame division unit 101 and the MDCT coefficients yk output from the MDCT unit 103, and normalizes the MDCT coefficients using several parameters. To normalize the MDCT coefficients is to suppress variations in values of MDCT coefficients, which values are considerably different between the low-band component and the high-band component. For example, when the low-band component is considerably larger than the high-band component, a parameter having a large value in the low-band component and a small value in the high-band component is selected, and the MDCT coefficients are divided by this parameter to suppress the variations of the MDCT coefficients. In the normalization unit 104, the indices IND1 expressing the parameters used for the normalization are coded.

The quantization unit 105 receives the MDCT coefficients normalized in the normalization unit 104, and quantizes the MDCT coefficients. At this time, the quantization unit 105 outputs a code index having a minimum difference among differences between the quantized values and the respective quantized outputs corresponding to plural code indices in a code book. In this case, a difference between the value quantized by the quantization unit 105 and the value corresponding to the code index output from the quantization unit 105 is a quantization error.

On the other hand, in the decoding apparatus 2, decoding is carried out using the indices IND1 from the normalization unit 104 in the coding apparatus 1, and the indices IND2 from the quantization unit 105. In the inverse quantization unit 106, the normalized MDCT coefficients are reproduced using the indices IND2 from the quantization unit 105. In the inverse quantization unit 106, the reproduction of the MDCT coefficients may be carried out using all or some of the indices. Of course, the output from the normalization unit 104 and the output from the inverse quantization unit 106 are not always identical to those before the quantization because the quantization by the quantization unit 105 is attended with quantization errors.

In the inverse normalization unit 107, the parameters used for the normalization in the coding apparatus 1 are restored from the indices IND1 output from the normalization unit 104 of the coding apparatus 1, and the output from the inverse quantization unit 106 is multiplied by these parameters to restore the MDCT coefficients. In the inverse MDCT unit 108, the MDCT coefficients output from the inverse normalization unit 107 are subjected to inverse MDCT, whereby the frequency-domain signal is restored to the time-domain signal. The inverse MDCT calculation is represented by, for example, formula (3).

$$xx(n) = \frac{2}{N}\sum_{k=0}^{N-1} yy_k \cos\left(\frac{2\pi(k+1/2)(n+n_0)}{N}\right) \qquad (3)$$

$$n_0 = N/4+1/2$$

where yyk is the MDCT coefficients restored in the inverse normalization unit 107, and xx(n) is the inverse MDCT coefficients which are output from the inverse MDCT unit 108.

The window multiplication unit 109 performs window multiplication using the output xx(n) from the inverse MDCT unit 108. The window multiplication is carried out using the same window as used by the window multiplication unit 102 of the coding apparatus 1, and a process shown by, for example, formula (4) is carried out.

$$z(i) = xx(i) \cdot hi \qquad (4)$$

where z(i) is the output from the window multiplication unit 109.

The frame overlapping unit 110 reproduces the audio signal using the output from the window multiplication unit 109. Since the output from the window multiplication unit 109 is a temporally overlapped signal, the frame overlapping unit 110 provides an output signal from the decoding apparatus 2 using, for example, formula (5).

$$out(i) = z_m(i) + z_{m-1}(i+SHIFT) \qquad (5)$$

where $z_m(i)$ is the i-th output signal $z(i)$ from the window multiplication unit 109 in the m-th time frame, $z_{m-1}(i)$ is the i-th output signal from the window multiplication unit 19 in the (m-1)th time frame, SHIFT is the sample number corresponding to the shift length of the coding apparatus, and out(i) is the output signal from the decoding apparatus 2 in the m-th time frame of the frame overlapping unit 110.

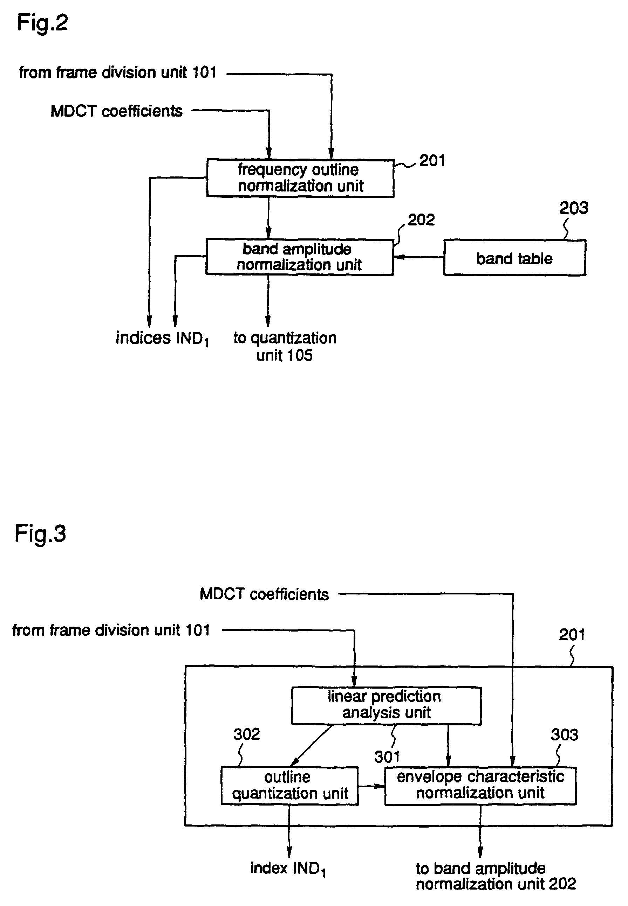

An example of the normalization unit 104 will be described in detail using figure 2. In figure 2, reference numeral 201 denotes a frequency outline normalization unit that receives the outputs from the frame division unit 101 and the MDCT unit 103; and 202 denotes a band amplitude normalization unit that receives the output from the frequency outline normalization unit 201 and performs normalization with reference to a band table 203.

A description is given of the operation. The frequency outline normalization unit 201 calculates a frequency outline, that is, a rough form of frequency, using the data on the time axis output from the frame division unit 101, and divides the MDCT coefficients output from the MDCT unit 103 by this. Parameters used for expressing the frequency outline are coded as indices IND1. The band amplitude normalization unit 202 receives the output signal from the frequency outline normalization unit 201, and performs normalization for each band shown in the band table 203. For example, assuming that the MDCT coefficients output from the frequency outline normalization unit 201 are dct(i) (i=0~2047) and the band table 203 is as shown by Table 1, an average value of amplitude in each band is calculated using, for example, formula (6).

(Table 1)

| j | bjlow | bjhigh |
|---|---|---|
| 0 | 0 | 10 |
| 1 | 11 | 22 |
| 2 | 23 | 33 |
| 3 | 34 | 45 |
| 4 | 46 | 56 |
| 5 | 57 | 68 |
| 6 | 69 | 80 |
| 7 | 81 | 92 |
| 8 | 93 | 104 |
| 9 | 105 | 116 |
| 10 | 117 | 128 |
| 11 | 129 | 141 |
| 12 | 142 | 153 |
| 13 | 154 | 166 |
| 14 | 167 | 179 |
| 15 | 180 | 192 |
| 16 | 193 | 205 |
| 17 | 206 | 219 |
| 18 | 220 | 233 |
| 19 | 234 | 247 |
| 20 | 248 | 261 |
| 21 | 262 | 276 |
| 22 | 277 | 291 |
| 23 | 292 | 307 |
| 24 | 308 | 323 |
| 25 | 324 | 339 |
| 26 | 340 | 356 |
| 27 | 357 | 374 |
| 28 | 375 | 392 |
| 29 | 393 | 410 |
| 30 | 411 | 430 |
| 31 | 431 | 450 |
| 32 | 451 | 470 |
| 33 | 471 | 492 |
| 34 | 493 | 515 |
| 35 | 516 | 538 |

| j | bjlow | bjhigh |
|---|---|---|
| 36 | 539 | 563 |
| 37 | 564 | 588 |
| 38 | 589 | 615 |
| 39 | 616 | 644 |
| 40 | 645 | 673 |
| 41 | 674 | 705 |
| 42 | 706 | 737 |
| 43 | 738 | 772 |
| 44 | 773 | 809 |
| 45 | 810 | 848 |
| 46 | 849 | 889 |
| 47 | 890 | 932 |
| 48 | 933 | 978 |
| 49 | 979 | 1027 |
| 50 | 1028 | 1079 |
| 51 | 1080 | 1135 |
| 52 | 1136 | 1193 |
| 53 | 1194 | 1255 |
| 54 | 1256 | 1320 |
| 55 | 1321 | 1389 |
| 56 | 1390 | 1462 |
| 57 | 1463 | 1538 |
| 58 | 1539 | 1617 |
| 59 | 1618 | 1699 |
| 60 | 1700 | 1783 |
| 61 | 1784 | 1870 |
| 62 | 1871 | 1958 |
| 63 | 1959 | 2048 |

( 6 )

$$sum_j = \sum_{i=bjlow}^{bjhigh} dct(i)^p$$
$$ave_j = \left( \frac{sum_j}{bjhigh - bjlow + 1} \right)^{-p}$$
$$\left. \right\} \quad bjlow \leq i \leq bjhigh$$

where bjlow and bjhigh are the lowest-band index i and the highest-band index i, respectively, in which the dct(i) in the j-th band shown in the band table 203 belongs Further, p is the norm in distance calculation, which is desired to be 2, and avej is the average of amplitude in each band number j. The band amplitude normalization unit 202 quantizes the avej to obtain qavej, and normalizes it using, for example, formula (7).

$$n\_dct(i) = dct(i)/qave_j \qquad bjlow \leq i \leq bjhigh \qquad (7)$$

To quantize the avej, scalar quantization may be employed, or vector quantization may be carried out using the code book. The band amplitude normalization unit 202 codes the indices IND1 of parameters used for expressing the qavej.

Although the normalization unit 104 in the coding apparatus 1 is constructed using both of the frequency outline normalization unit 201 and the band amplitude normalization unit 202 as shown in figure 2, it may be constructed using either of the frequency outline normalization unit 201 and the band amplitude normalization unit 202. Further, when there is no significant variation between the low-band component and the high-band component of the MDCT coefficients output from the MDCT unit 103, the output from the MDCT unit 103 may be directly input to the quantization unit 105 without using the units 201 and 202.

The frequency outline normalization unit 201 shown in figure 2 will be described in detail using figure 3. In figure 3, reference numeral 301 denotes a linear predictive analysis unit that receives the output from the frame division unit 101; 302 denotes an outline quantization unit that receives the output from the linear predictive analysis unit 301; and 303 denotes an envelope characteristic normalization unit that receives the output from the MDCT unit 103.

A description is given of the operation of the frequency outline normalization unit 201. The linear predictive analysis unit 301 receives the audio signal on the time axis from the frame division unit 101, and performs linear predictive coding. Linear predictive coefficients (LPC coefficients) as the result of linear predictive coding can generally be obtained by calculating an autocorrelation function of a window-multiplied signal, such as Humming window, and solving a normal equation or the like. The linear predictive coefficients so calculated are converted to linear spectral pair coefficients (LSP coefficients) or the like and quantized in the outline quantization unit 302. As a quantization method, vector quantization or scalar quantization may be employed. Then, frequency transfer characteristic expressed by the parameters quantized by the outline quantization unit 302 is calculated in the envelope characteristic normalization unit 303, and the MDCT coefficients output from the MDCT unit 103 are divided by the characteristic to be normalized. To be specific, when the linear predictive coefficients equivalent to the parameters quantized by the outline quantization unit 302 are qlpc(i), the frequency transfer characteristic calculated by the envelope characteristic normalization unit 303 is expressed by, for example, formula (8).

$$li = \begin{cases} qlpc(i) & 0 \leq i \leq ORDER \\ 0 & ORDER + 1 \leq i < N \end{cases}$$

$$env(i) = 1 / fft(li) \qquad (8)$$

where ORDER is desired to be 10~40, and fft( ) means high-speed Fourier transform. Using the calculated frequency transfer characteristic env(i), the envelope characteristic normalization unit 303 performs normalization using, for example, formula (9) as follows.

$$fdct(i) = mdct(i)/env(i) \qquad (9)$$

where mdct(i) is the output signal from the MDCT unit 103, and fdct(i) is the normalized output signal from the envelope characteristic normalization unit 303.

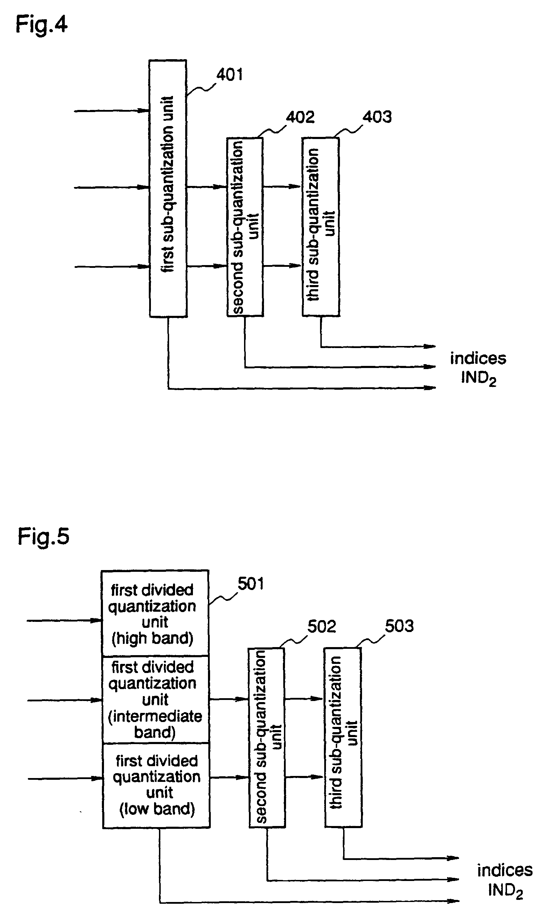

Next, the quantization unit 105 in the coding apparatus 1 will be described in detail using figure 4. In figure 4, reference numeral 401 denotes a first sub-quantization unit, 402 denotes a second sub-quantization unit that receives the output from the first sub-quantization unit, and 403 denotes a third sub-quantization unit that receives the output from the second sub-quantization unit 402.

Next, the operation of the quantization unit 105 will be described. A signal input to the first sub-quantization unit 401 is the output from the normalization unit 104 of the coding apparatus, i.e., normalized MDCT coefficients. However, in the structure having no normalization unit 104, it is the output from the MDCT unit 103. In the first sub-quantization unit 401, the input MDCT coefficients are subjected to scalar quantization or vector quantization, and the indices expressing the parameters used for the quantization are coded. Further, quantization errors with respect to the input MDCT coefficients due to the quantization are calculated, and they are output to the second sub-quantization unit 402. In the first sub-quantization unit 401, all of the MDCT coefficients may be quantized, or only a portion of them may be quantized. Of course, when only a portion thereof is quantized, quantization errors in the bands which are not quantized by the first sub-quantization unit 401 will become input MDCT coefficients of the non-quantized bands.

Next, the second sub-quantization unit 402 receives the quantization errors of the MDCT coefficients obtained in the first sub-quantization unit 401, and quantizes them. For this quantization, like the first sub-quantization unit 401, scalar quantization or vector quantization may be used. The second sub-quantization unit 402 codes the parameters used for the quantization as indices. Further, it calculates quantization errors due to the quantization, and outputs them to the third sub-quantization unit 403. This third sub-quantization unit 403 is identical in structure to the second sub-quantization unit. The numbers of MDCT coefficients, i.e., band widths, to be quantized by the first sub-quantization unit 401, the second sub-quantization unit 402, and the third sub-quantization unit 403 are not necessarily equal to each other, and the bands to be quantized are not necessarily the same. Considering the auditive characteristic of human beings, it is desired that both of the second sub-quantization unit 402 and the third sub-quantization unit 403 are set so as to quantize the band of the MDCT coefficients showing the low-frequency component.

As described above, in the audio signal coding apparatus according to the first embodiment, when quantization is performed, the quantization unit is provided in stages, i.e., a multiple-stage quantization means is constituted, and the band width to be quantized by the quantization unit is varied between the adjacent stages, whereby coefficients in an arbitrary band among the input MDCT coefficients, for example, coefficients corresponding to the low-frequency component which is auditively important for human beings, are quantized preponderantly. Therefore, even when an audio signal is coded at a low bit rate, i.e., a high compression ratio, it is possible to perform high-definition audio reproduction at the receiving end.

**Embodiment 2**

Next, an audio signal coding apparatus according to a second embodiment of the invention will be described using figure 5. In this second embodiment, only the structure of the quantization unit 105 in the coding apparatus 1 is different from that of the first embodiment and, therefore, only the structure of the quantization unit will be described hereinafter. In figure 5, reference numeral 501 denotes a first sub-quantization unit, 502 denotes a second sub-quantization unit, and 503 denotes a third sub-quantization unit. This fifth embodiment is different in structure from the first embodiment in that the first quantization unit 501 divides the input MDCT coefficients into three bands (high-band, intermediate-band, low-band) and quantizes the respective bands independently, and quantization sections for the respective bands, which constitute the first sub-quantization unit 501, correspond to so-called "divided vector quantizers". Generally, when quantization is carried out using a method of vector quantization, a vector is constituted by extracting some elements from the input MDCT coefficients, whereby vector quantization is performed. In the first sub-quantization unit 501 according to this seventh embodiment, when constituting a vector by extracting some elements from the input MDCT coefficients, quantization of the low band is performed using only the elements in the low band, quantization of the intermediate band is performed using only the elements in the intermediate band, and quantization of the high band is performed using only the elements in the high band, whereby the respective bands are subjected to vector quantization.

Although in this second embodiment, a method of dividing the band to be quantized into three bands, i.e., low band, intermediate band, and high band, is described as an example, the number of divided bands may be other than three. Further, with respective to the second sub-quantization unit 502 and the third sub-quantization unit 503, as well as the first quantization unit 501, the band to be quantized may be divided into several bands.

As described above, according to the second embodiment of the invention, in the multiple-stage quantization means, initially in the first stage, the input MDCT coefficients are divided into three bands and quantized independently, so that the process of quantizing the auditively important band with priority can be performed in the first-time quantization. Further, in the subsequent quantization units 502 and 503, the MDCT coefficients in the auditively important band are further quantized by stages, whereby the quantization error is reduced furthermore, and higher-definition audio reproduction is realized on the receiving end.

**Embodiment 3**

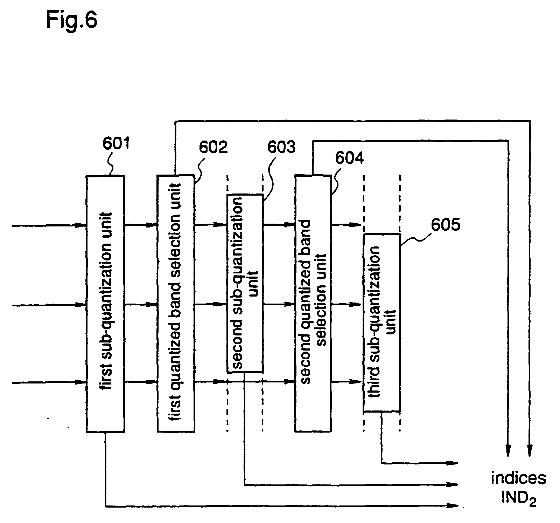

An audio signal coding apparatus according to a third embodiment of the present invention will be described using figure 6. In this third embodiment, since only the structure of the quantization unit 105 in the coding apparatus 1 is different from that of the above-mentioned first embodiment, only the structure of the quantization unit will be explained. In figure 6, reference numeral 601 denotes a first sub-quantization unit, 602 denotes a first quantization band selection unit, 603 denotes a second sub-quantization unit, 604 denotes a second quantization band selection unit, and 605 denotes a third sub-quantization unit. This third embodiment is different in structure from the second embodiment in that the first quantization band selection unit 602 and the second quantization band selection unit 604 are added.

Hereinafter, the operation will be described. The first quantization band selection unit 602 calculates a band, of which MDCT coefficients are to be quantized by the second sub-quantization unit 602, using the quantization error (fdcterr(i)) output from the first sub-quantization unit 601.

For example, j which maximizes esum(j) given in formula (10) is calculated, and a band ranging from j*OFFSET to j*OFFSET+ BANDWIDTH is quantized.

$$esum(j) = \sum_{i=j\,OFFSET}^{j\text{-}OFFSET+BANDWIDTH} fdct_{err}(i)^2 \qquad (10)$$

where OFFSET is the constant, and BANDWIDTH is the total sample corresponding to a band width to be quantized by the second sub-quantization unit 603. The first quantization band selection unit 602 codes, for example, the j which gives the maximum value in formula (10), as an index IND2. The second sub-quantization unit 603 receives the index IND2 and quantizes the band selected by the first quantization band selection unit 602. The second quantization band selection unit 604 is implemented by the same structure as the first selection unit 602 except that its input is the quantization error output from the second sub-quantization unit 603, and the band selected by the second quantization band selection unit 604 is input to the third sub-quantization unit 605.

Although in the first quantization band selection unit 602 and the second quantization band selection unit 604, a band to be quantized by the next quantization unit is selected using formula (10), a band to be quantized may be calculated using a value obtained by multiplying a value used for normalization by the normalization unit 104 and a value in view of the auditive sensitivity characteristic of human beings relative to frequencies, as shown in formula (11).

$$esum(j) = \sum_{i=j\,OFFSET}^{j\text{-}OFFSET+BANDWIDTH} \{fdct_{err}(i) \cdot env(i) \cdot zxc(i)\}^2 \qquad (11)$$

where env(i) is obtained by dividing the output from the MDCT unit 103 with the output from the normalization unit 104, and zxc(i) is the table in view of the auditive sensitivity characteristic of human beings relative to frequencies, and an example thereof is shown in (Graph 2). In formula (11), zxc(i) may be always 1 so that it is not considered.

(Graph 2)

Further, it is not necessary to provide plural stages of quantization band selection units, i.e., only the first quantization band selection unit 602 or the second quantization band selection unit 604 may be used.

As described above, according to the third embodiment, when quantization is performed in multiple stages, a quantization band selection unit is disposed between adjacent stages of quantization units to make the band to be quantized variable and appropriately selectable. Therefore, the band to be quantized can be varied according to the input signal, and the degree of freedom in quantization is increased, whereby the quantization efficiency is significantly improved by preponderantly quantizing a portion which needs quantization.

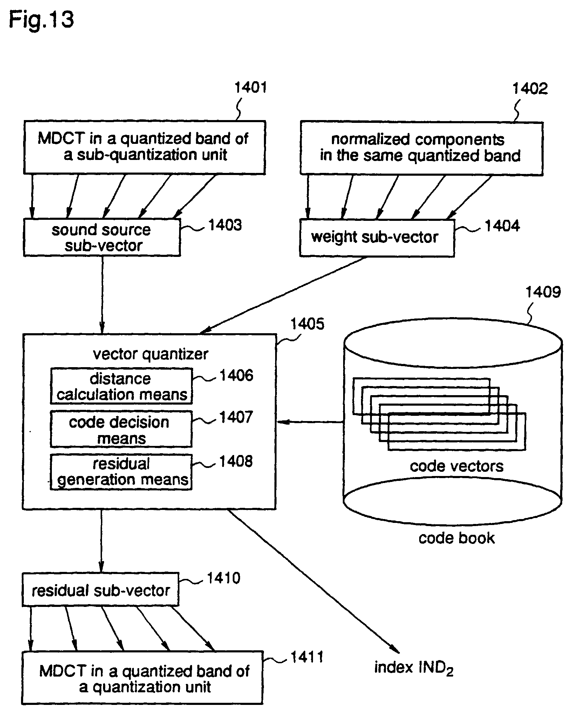

Hereinafter, a description is given of the detailed operation by a quantization method of the quantization unit 106 included in the coding apparatus 1 according to any of the first to third embodiments, using figure 1 and figure 13. From the MDCT coefficients 1401 input to each sub-quantization unit, some of them are extracted to constitute sound source sub-vectors 1403. Likewise, assuming that the coefficient streams, which are obtained by dividing the MDCT coefficients input to the normalization unit 104 with the MDCT coefficients 1401 output from the normalization unit 104, are normalized components 1402, some of these components are extracted according to the same rule as that for extracting the sound source sub-vectors from the MDCT coefficients 1401, thereby to constitute weight sub-vectors 1404. The rule for extracting the sound source sub-vectors 1403 and the weight sub-vectors 1404 from the MDCT coefficients 1401 and the normalized components 1402, respectively, is shown in, for example, formula (14).

$$subvector_i(j) = \begin{cases} vector\left(\dfrac{VTOTAL}{CR} \cdot i + j\right) & \dfrac{VTOTAL}{CR} \cdot i + j < TOTAL \\ \\ 0 & \dfrac{VTOTAL}{CR} \cdot i + j \geq TOTAL \end{cases} \qquad (14)$$

where the j-th element of the i-th sound source sub-vector is subvector$_i$(j), the MDCT coefficients are vector( ), the total element number of the MDCT coefficients 1401 is TOTAL, the element number of the sound source sub-vectors 1403 is CR, and VTOTAL is set to a value equal to or larger than TOTAL and VTOTAL/CR should be an integer. For example, when TOTAL is 2048, CR=19 and VTOTAL=2052, or CR=23 and VTOTAL=2070, or CR=21 and VTOTAL=2079. The weight sub-vectors 1404 can be extracted by the procedure of formula (14).

The vector quantizer 1405 selects, from the code vectors in the code book 1409, a code vector having a minimum distance between it and the sound source sub-vector 1403 after being weighted by the weight sub-vector 1404. Then, the quantizer 1405 outputs an index IND2 of the code vector having the minimum distance, and a residual sub-vector 1404 which corresponds to a quantization error between the code vector having the minimum distance and the input sound source sub-vector 1403. An example of actual calculation procedure will be described on the premise that the vector quantizer 1405 is composed of three constituents: a distance calculating means 1406, a code decision means 1407, and a residual generating means 1408. The distance calculating means 1406 calculates the distance between the i-th sound source sub-vector 1403 and the k-th code vector in the code book 1409 using, for example, formula (15).

$$dik = \sum_{j=0}^{CR-1} w_J{}^R (subvector_i(j) - C_k(j))^S \qquad (15)$$

where wj is the j-th element of the weight sub-vectors, ck(j) is the j-th element of the k-th code vector, R and S are norms for distance calculation, and the values of R and S are desired to be 1, 1.5, 2. These norms R and S for distance calculation may have different values. Further, dik is the distance of the k-th code vector from the i-th sound source sub-vector. The code decision means 1407 selects a code vector having a minimum distance among the distances calculated by formula (15) or the like, and codes the index thereof (IND2). For example, when diu is the minimum value, the index to be coded for the i-th sub-vector is u. The residual generating means 1408 generates the residual sub-vectors 1410 using the code vectors selected by the code decision means 1407, according to formula (16).

$$res_i(j) = subvector_i(j) - C_u(j) \qquad (16)$$

wherein the j-th element of the i-th residual sub-vector 1410 is resi(j), and the j-th element of the u-th code vector selected by the code decision means 1407 is cu(j). The residual sub-vectors 1410 are retained as MDCT coefficients to be quantized by the subsequent sub-quantization units, by executing the inverse process of formula (14) or the like. However, when a band being quantized does not influence on the subsequent sub-quantization units, i.e., when the subsequent sub-quantization units are not required to perform quantization, the residual generating means 1408, the residual sub-vectors 1410, and the generation of the MDCT 1411 are not necessary. Although the number of code vectors possessed by the code book 1409 is not specified, when the memory capacity, calculating time and the like are considered, the number is desired to be about 64.

As another embodiment of the vector quantizer 1405, the following structure is available. That is, the distance calculating means 1406 calculates the distance using formula (17).

$$dik = \begin{cases} \sum_{j=0}^{CR-1} w_j{}^R (subvector_i(j) - C_k(j))^S & k < K \\ \\ \sum_{j=0}^{CR-1} w_j{}^R (subvector_i(j) - C_{K-k}(j))^S & k \geq K \end{cases} \qquad (17)$$

wherein K is the total number of code vectors used for the code retrieval of the code book 1409.

The code decision means 1407 selects k that gives a minimum value of the distance dik calculated in formula (17), and codes the index thereof (IND2). Here, k is a value in a range from 0 to 2K-1. The residual generating means 1408 generates the residual sub-vectors 1410 using formula (18).

$$resi(j) = \begin{cases} subvector_i(j) - C_u(j) & 0 \leq k < K \\ subvector_i(j) + C_u(j) & K \leq k < 2K \end{cases} \qquad (18)$$

Although the number of code vectors possessed by the code book 1409 is not restricted, when the memory capacity, calculation time and the like are considered, it is desired to be about 64.

Further, although the weight sub-vectors 1404 are generated from the normalized components 1402, it is possible to generate weight sub-vectors by multiplying the weight sub-vectors 1404 by a weight in view of the auditive characteristic of human beings.

According to the third embodiment described above, the first quantization band selection unit is disposed between the first sub-quantization unit and the second sub-quantization unit, and the second quantization band selection unit is disposed between the second sub-quantization unit and the third sub-quantization unit, thereby to make the bands to be quantized by the second sub-quantization unit and the third sub-quantization unit variable and appropriately selectable. Therefore, the band to be quantized can be varied according to the input signal, and the degree of freedom in quantization is improved, whereby the quantization efficiency is significantly improved by preponderantly quantizing a portion which needs quantization.

Furthermore, according to the first to third embodiments described above, an audio signal coding apparatus for coding an audio signal by performing vector quantization to a frequency characteristic signal sequence obtained by frequency transformation of an input audio signal, is provided with a multiple-stage quantization means having, at least, a first-stage vector quantizer for vector-quantizing the frequency characteristic signal sequence or a portion thereof, and a second-stage vector quantizer for vector-quantizing a quantization error component from the first-stage vector quantizer; and each stage of the multiple-stage quantization means is provided with at least one divided vector quantizer which vector-quantizes coefficient streams of any of plural frequency bands which are obtained by dividing the frequency characteristic signal sequence into at least two frequency bands which may have an overlapped portion between the plural stages, according to a division manner for each stage. In this structure, among input MDCT coefficients, coefficients in an arbitrary band, for example, coefficients corresponding to a low-frequency-band component which is auditively important for human beings, are quantized preponderantly to a desired depth. On the other hand, at the decoding end, decoding can be carried out using codes decoded in multiple stages, and the decoding order can be alternately decoding codes contributing to band expansion and codes contributing to quality improvement. Therefore, even though the audio signal is coded at a low bit rate, i.e., a high compression ratio, or even though coding and decoding are carried out without a fixed data quantity, it is possible to perform high-definition audio reproduction on the receiving end.

**Embodiment 4**

Next, an audio signal decoding apparatus according to a fourth embodiment of the present invention will be described using figure 1 and figures 7~11. The indices output from the coding apparatus 1 are broadly divided into the indices IND1 output from the normalization unit 104 and the indices IND2 output from the quantization unit 105. The indices IND1 output from the normalization unit 104 are decoded by the inverse normalization unit 107, and the indices IND2 output from the quantization unit 105 are decoded by the inverse quantization unit 106. The inverse quantization unit 106 can perform decoding using only a portion of the indices IND2 output from the quantization unit 105.

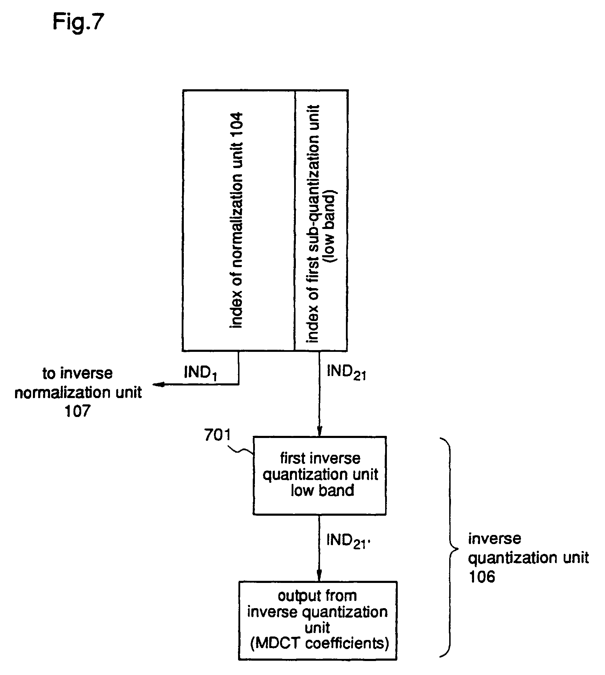

That is, assuming that the quantization unit 105 of the coding apparatus 1 has the structure shown in figure 5, a description is given of the case where inverse quantization is carried out using the inverse quantization unit having the structure of figure 7 in the decoding apparatus 2. In figure 7, reference numeral 701 designates a first low-band-component inverse quantization unit. The first low-band-component inverse quantization unit 701 performs decoding using only the indices IND21 of the low-band component from the first sub-quantizer 501.

By the structure described above, i.e., by performing decoding using only the indices of the low-band component from the first sub-quantization unit 501 in the first low-band-component inverse quantization unit 701, a desired quantity of data of the coded audio signal can be decoded regardless of the quantity of data transmitted from the coding apparatus 1. That is, even when the quantity of data to be decoded at the receiving side is restricted, a desired quantity of data can be decoded by making the quantity of data to be coded different from the quantity of data to be decoded. Accordingly, the quantity of data to be decoded can be varied according to the communication environment or the like on the receiving end, and high-definition sound quality can be obtained stably even when an ordinary public telephone network is used.

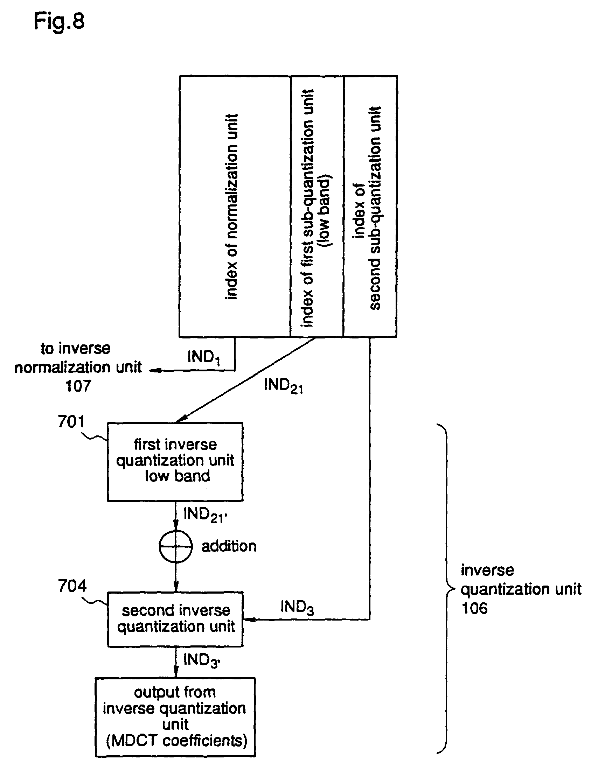

Figure 8 is a diagram showing the structure of the inverse quantization unit included in the audio signal decoding apparatus, which is employed when inverse quantization is carried out in two stages. In figure 8, reference numeral 704 denotes a second inverse quantization unit. This second inverse quantization unit 704 performs decoding using the indices IND3 from the second sub-quantization unit 502. Accordingly, the output IND21' from the first low-band-component inverse quantization unit 701 and the output IND3' from the second inverse quantization unit 704 are added and their sum is output from the inverse quantization unit 106. This addition is performed to the same band as the band quantized by each sub-quantization unit in the quantization.

As described above, the indices IND21 from the first sub-quantization unit (low-band) are decoded by the first low-band-component inverse quantization unit 701 and, when the indices IND3 from the second sub-quantization unit are inversely quantized, the output IND21' from the first low-band-component inverse quantization unit 701 is added to the object of the inverse quantization, whereby the inverse quantization is carried out in two stages. Therefore, the audio signal quantized in multiple stages can be decoded accurately, resulting in a higher sound quality.

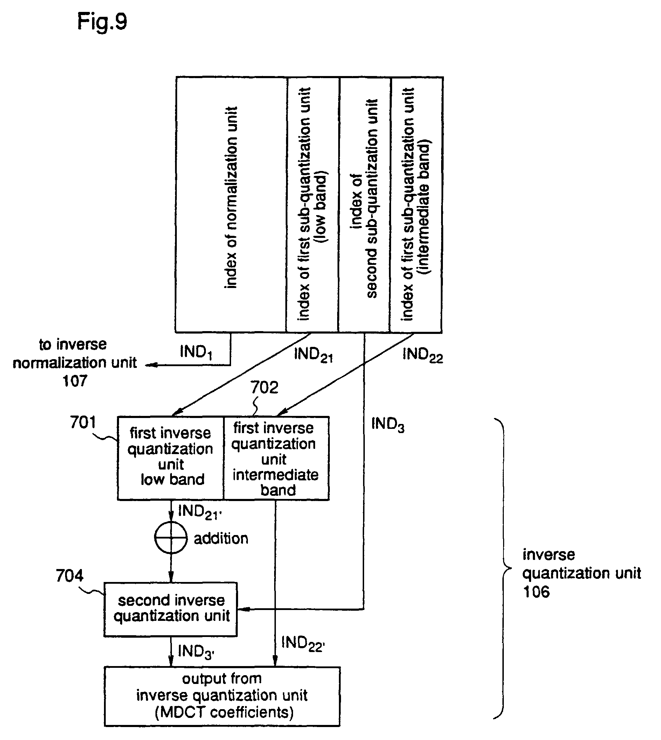

Further, figure 9 is a diagram illustrating the structure of the inverse quantization unit included in the audio signal decoding apparatus, in which the object band to be processed is extended when the two-stage inverse quantization is carried out. In figure 9, reference numeral 702 denotes a first intermediate-band-component inverse quantization unit. This first intermediate-band-component inverse quantization unit 702 performs decoding using the indices IND22 of the intermediate-band component from the first sub-quantization unit 501. Accordingly, the output IND21' from the first low-band-component inverse quantization unit 701, the output IND3' from the second inverse quantization unit 704, and the output IND22' from the first intermediate-band-component inverse quantization unit 702 are added and their sum is output from the inverse quantization unit 106. This addition is performed to the same band as the band quantized by each sub-quantization unit in the quantization. Thereby, the band of the reproduced sound is extended, and an audio signal of higher quality is reproduced.

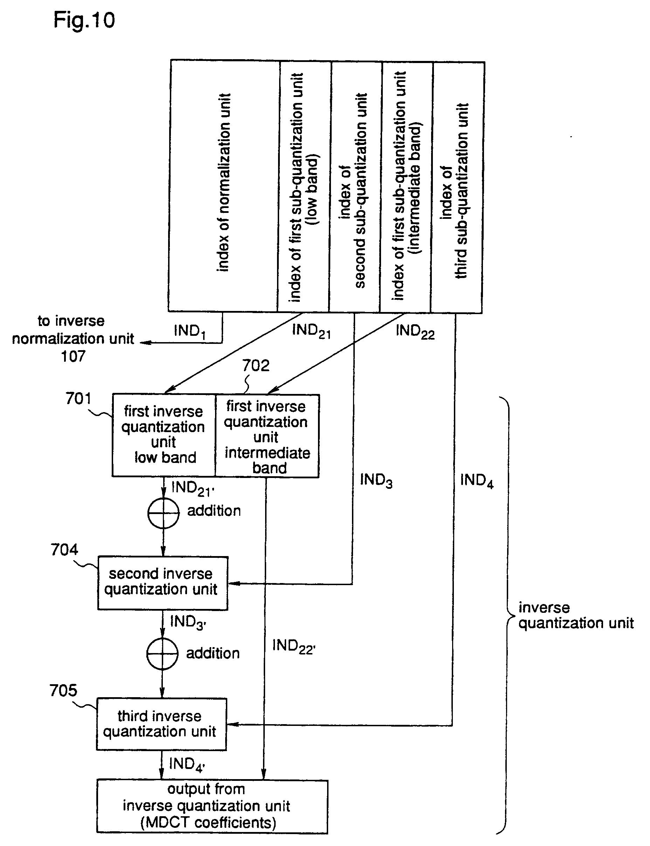

Further, figure 10 is a diagram showing the structure of the inverse quantization unit included in the audio signal decoding apparatus, in which inverse quantization is carried out in three stages by the inverse quantization unit having the structure of figure 9. In figure 10, reference numeral 705 denotes a third inverse quantization unit. The third inverse quantization unit 705 performs decoding using the indices from the third sub-quantization unit 503. Accordingly, the output IND21' from the first low-band-component inverse quantization unit 701, the output IND3' from the second inverse quantization unit 704, the output IND22' from the first intermediate-band-component inverse quantization unit 702, and the output IND4' from the third inverse quantization unit 705 are added and their sum is output from the inverse quantization unit 106. This addition is performed to the same band as the band quantized by each sub-quantization unit in the quantization.

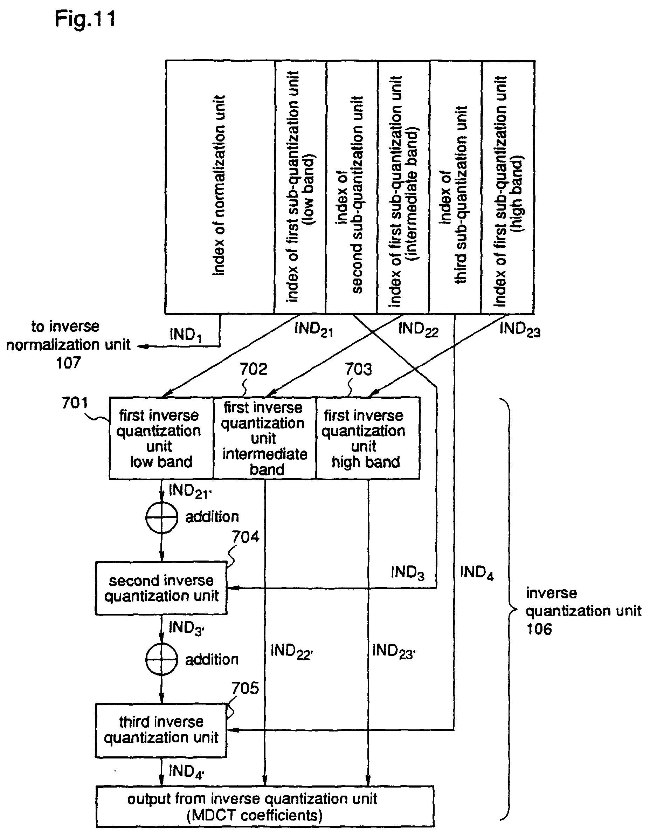

Further, figure 11 is a diagram illustrating the structure of the inverse quantization unit included in the audio signal decoding apparatus, in which the object band to be processed is extended when the three-stage inverse quantization is carried out in the inverse quantization unit having the structure of figure 10. In figure 11, reference numeral 703 denotes a first high-band-component inverse quantization unit. This first high-band-component inverse quantization unit 703 performs decoding using the indices of the high-band component from the first sub-quantization unit 501. Accordingly, the output IND21' from the first low-band-component inverse quantization unit 701, the output IND3' from the second inverse quantization unit 704, the output IND22' from the first intermediate-band-component inverse quantization unit 702, the output IND4' from the third inverse quantization unit 705, and the output IND23' from the first high-band-component inverse quantization unit 703 are added and their sum is output from the inverse quantization unit 106. This addition is performed to the same band as the band quantized by each sub-quantization unit in the quantization.

While this fourth embodiment is described for the case where the decoding unit 106 inversely decodes the data quantized by the quantization unit 105 having the structure of figure 5, similar inverse quantization can be performed even when the quantization unit 105 has the structure shown in figure 4 or 6.

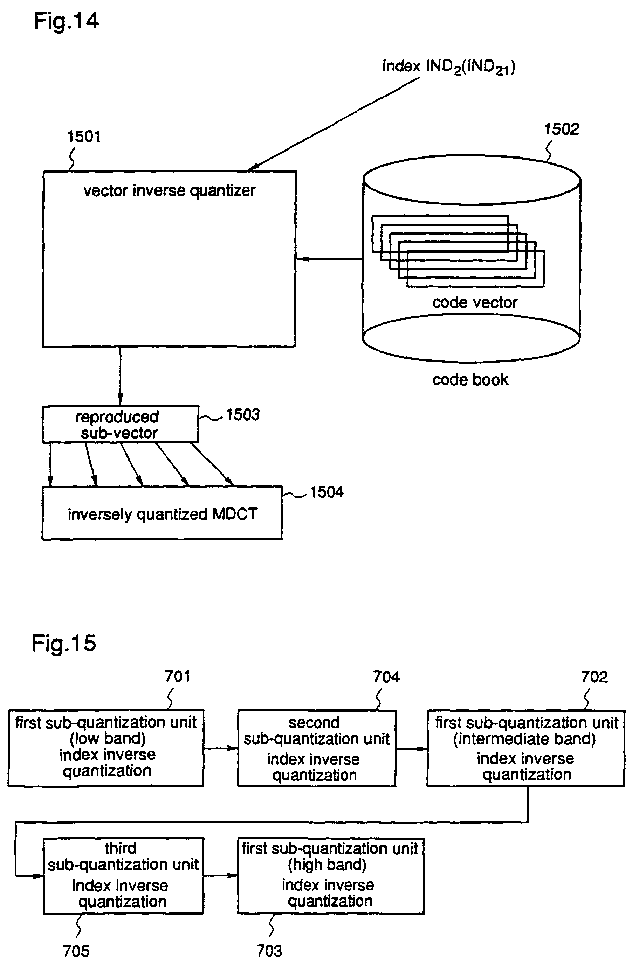

Furthermore, when coding is carried out using the quantization unit having the structure shown in figure 5 and decoding is carried out using the inverse quantization unit having the structure shown in figure 11, as shown in figure 15, after the low-band indices from the first sub-quantization unit are inversely quantized, the indices from the second sub-quantization unit 502 in the next stage are inversely quantized, and then the intermediate-band indices from the first sub-quantization unit are inversely quantized. In this way, the inverse quantization to extend the band and the inverse quantization to reduce the quantization error are alternatingly repeated. However, when a signal coded by the quantization unit having the structure shown in figure 4 is decoded using the inverse quantization unit having the structure shown in figure 11, since there is no divided bands in the structure of figure 4, the quantized coefficients are successively decoded by the inverse quantization unit in the next stage.

A description is given of the detailed operation of the inverse quantization unit 106 as a constituent of the audio signal decoding apparatus 2, using figure 1 and figure 14. For example, the inverse quantization unit 106 is composed of the first low-band inverse quantization unit 701 when it has the inverse quantization unit shown in figure 7, and it is composed of two inverse quantization units, i.e., the first low-band inverse quantization unit 701 and the second inverse quantization unit 704, when it has the inverse quantization unit shown in figure 8.

The vector inverse quantizer 1501 reproduces the MDCT coefficients using the indices IND2 from the vector quantization unit 105 in the coding apparatus 1. When the sub-quantization unit has the structure shown in figure 7, inverse quantization is carried out as follows. An index number is decoded from the indices IND21, and a code vector having the number is selected from the code book 1502. It is assumed that the content of the code book 1502 is identical to that of the code book of the coding apparatus 1. From the selected code vector, a reproduced sub-vector 1503 is obtained, and this becomes an inversely quantized MDCT coefficient (i,j) 1504 in the inverse process of formula (14).

When the sub-quantization unit has the structure shown in figure 8, inverse quantization is carried out as follows. An index number k is decoded from the indices IND21 and IND3, and a code vector having the number u calculated in formula (19) is selected from the code book 1502.

$$u = \begin{cases} k & 0 \le k < K \\ k - K & K \le k < 2K \end{cases} \tag{19}$$

A reproduced sub-vector is generated using formula (20).

$$resi(j) = \begin{cases} C_u(j) & u = k \\ -C_u(j) & u \ne k \end{cases} \tag{20}$$

wherein the j-th element of the i-th reproduced sub-vector is resi(j).

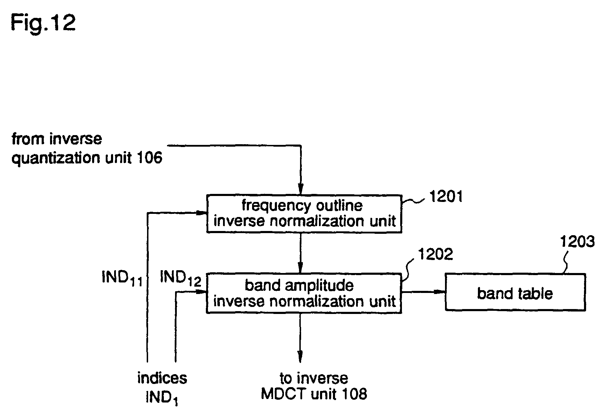

Next, a description is given of the detailed structure of the inverse normalization unit 107 as a constituent of the audio signal decoding apparatus 2, using figure 1 and figure 12. In figure 12, reference numeral 1201 denotes a frequency outline inverse quantization unit, 1202 denotes a band amplitude inverse normalization unit, and 1203 denotes a band table. The frequency outline inverse normalization unit 1201 receives the indices IND11 from the frequency outline normalization unit 1201, reproduces the frequency outline, and multiplies the output from the inverse quantization unit 106 by the frequency outline. The band amplitude inverse normalization unit 1202 receives the indices IND12 from the band amplitude normalization unit 202, and restores the amplitude of each band shown in the band table 1203, by multiplication. Assuming that the value of each band restored using the indices IND12 from the band amplitude normalization unit 202 is qavej, the operation of the band amplitude inverse normalization unit 1202 is given by formula (12).

$$dct(i) = n\_dct(i) \cdot qave_J \qquad bjlow \le i \le bjhigh \tag{12}$$

wherein the output from the frequency outline inverse normalization unit 1201 is n_dct(i), and the output from the band amplitude inverse normalization unit 1202 is dct(i). In addition, the band table 1203 and the band table 203 are identical.

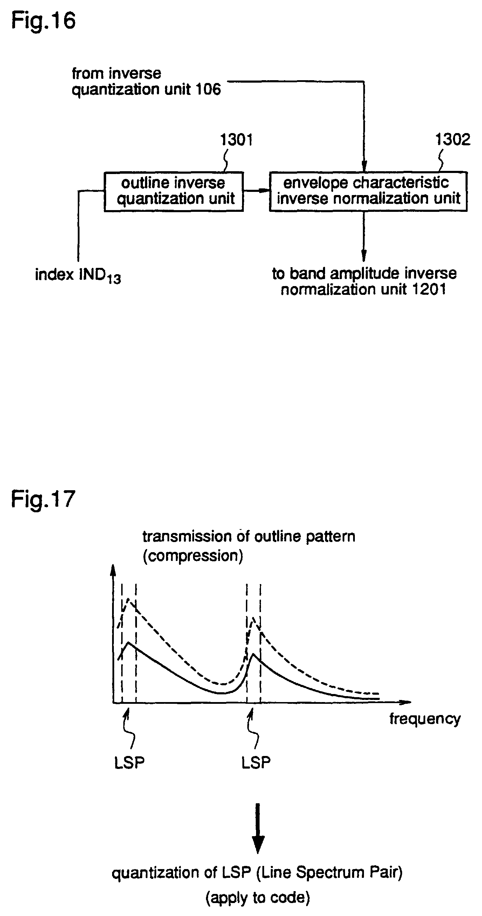

Next, a description is given of the detailed structure of the frequency outline inverse normalization unit 1201 as a constituent of the audio signal decoding apparatus 2, using figure 16. In figure 16, reference numeral 1301 designates an outline inverse quantization unit, and 1302 denotes an envelope characteristic inverse quantization unit. The outline inverse quantization unit 1301 restores parameters showing the frequency outline, for example, linear prediction coefficients, using the indices IND13 from the outline quantization unit 301 in the coding apparatus 1. When the restored coefficients are linear prediction coefficients, the quantized envelope characteristics E13 are restored by calculating them similarly in formula (8). When the restored coefficients are not linear prediction coefficients, for example, when they are LSP coefficients, the envelope characteristics E13 are restored by transforming them to frequency characteristics. The envelope characteristic inverse quantization unit 1302 multiplies the restored envelope characteristics E13 by the output IND16 from the inverse quantization unit 106 as shown in formula (13), and outputs the result toward the band amplitude inverse normalization unit 1201.

$$mdct(i) = fdct(i) \cdot env(i) \tag{13}$$

According to the fourth embodiment described above, a normalization means is provided before the quantization means, and normalization of an input audio signal is carried out before quantization. Therefore, the normalization means and the quantization means perform coding while exhibiting their full abilities, resulting in quantization of high efficiency, with less quantization error, without losing the data quantity possessed by the original audio signal. Further, when the data quantity at the receiving end is limited, inverse quantization is carried out only in a narrow band and a shallow region. However, by expanding the inverse quantization alternately in the direction to broaden the band and the direction to increase the depth of the inverse quantization to increase the data quantity at the receiving end, a desired quantity of data of the coded audio signal can be decoded regardless of the quantity of data transmitted from the coding apparatus 1. Accordingly, by varying the quantity of data to be decoded according to the communication environment or the like on the receiving end, high-definition sound quality can be obtained stably even when an ordinary public telephone network is used.

**Embodiment 5**

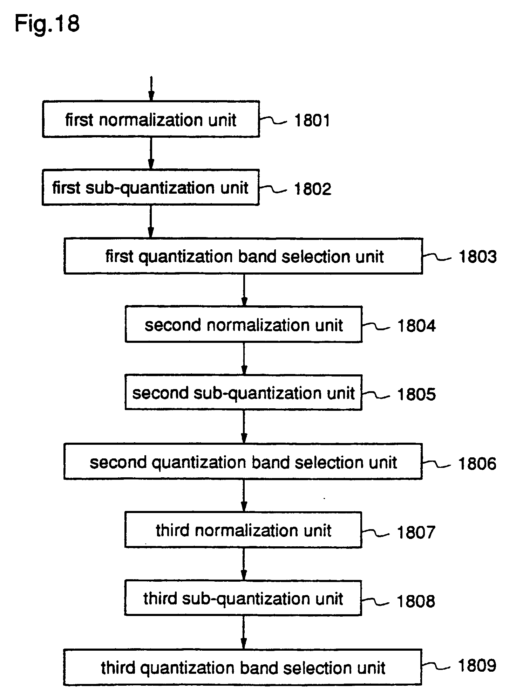

Next, an audio signal coding apparatus according to a fifth embodiment of the present invention will be described using figure 18. In this fifth embodiment, since only the structure of the quantization unit 105 in the coding apparatus 1 is different from those of the above-mentioned embodiments, only the structure of the quantization unit will be described, and description for other constituents is omitted.

In figure 18, reference numeral 1801 denotes a first sub-quantization unit, 1802 denotes a first sub-quantization unit, 1803 denotes a first quantization band selection unit, 1804 denotes a second normalization unit, 1805 denotes a second sub-quantization unit, 1806 denotes a second quantization band selection unit, 1807 denotes a third normalization unit, 1808 denotes a third sub-quantization unit, and 1809 denotes a third quantization band selection unit.

This fifth embodiment is different, in structure, from the third embodiment in that the second and third normalization units 1804 and 1807 are added.

Next, the respective constituents of the fifth embodiment will be described. The first, second, and third normalization units 1801, 1804, and 1807 are implemented by the same structure as the normalization unit 104 according to the first embodiment. The first, second, and third subquantization units 1802, 1805, and 1808 are implemented by the same structure as the first sub-quantization unit 601 according to the third embodiment. The first, second, and third quantization band selection units 1803, 1806, 1809 are implemented by the same structure as the first quantization band selection unit 602 according to the third embodiment. While in this fifth embodiment the coding apparatus has three sets of combinations each comprising a normalization unit, a sub-quantization unit, and a quantization band selection unit, the number of the sets is not restricted to three, it may be four or more, or it may be two. Further, the quantization band selection unit of the set in the final stage is not always necessary, i.e., it can be dispensed with.

Next, a description is given of the operation of the coding apparatus according to the fifth embodiment shown in figure 18.

In figure 18, MDCT coefficients of an audio signal input to the fifth embodiment are subjected to normalization in the first normalization unit 1801, and normalized MDCT coefficients are output. The first sub-quantization unit 1802 quantizes the normalized MDCT coefficients corresponding to a signal output from the first normalization unit 1801. The first sub-quantization unit 1802 outputs, as indices, parameters used for the quantization and, further, it outputs a quantization error generated in the quantization, toward the quantization band selection unit 1803 in the next stage. The first quantization band selection unit 1803 calculates a band, of which MDCT coefficients are to be quantized by the second sub-quantization unit 1805, using the output from the first sub-quantization unit 1802.

The second normalization unit 1804 normalizes the MDCT coefficients output from the first sub-quantization unit 1802, on the basis of the result selected by the first quantization band selection unit 1803, with respect to the selected band. The second sub-quantization unit 1805 quantizes the output from the second normalization unit 1804 and outputs, as indices, parameters used for the quantization, and a quantization error generated in the quantization. The second quantization band selection unit 1806 calculates a band, of which MDCT coefficients are to be quantized by the third sub-quantization unit 1808, using the output from the second sub-quantization unit 1805.

The third normalization unit 1807 normalizes the MDCT coefficients output from the second sub-quantization unit 1805, on the basis of the result selected by the second quantization band selection unit 1806, with respect to the selected band. The third sub-quantization unit 1808 quantizes the output from the third normalization unit 1807 and outputs, as indices, parameters used for the quantization, and a quantization error generated in the quantization.

The third quantization band selection unit 1809 shown in the figure is needed only when there is a fourth sub-quantization unit (not shown) in the subsequent stage. If the fourth sub-quantization unit is present, the third quantization band selection unit 1809 calculates a band, of which MDCT coefficients are to be quantized by the fourth sub-quantization unit, using the output from the third sub-quantization unit 1808. The first, second, and third normalization units 1801, 1804, and 1807 output, as indices, parameters used for normalization, like the normalization unit 105 according to the first embodiment.

Hereinafter, the operation and functional feature of the coding apparatus according to the fifth embodiment will be described in comparison with the coding apparatuses according to the first to third embodiments.

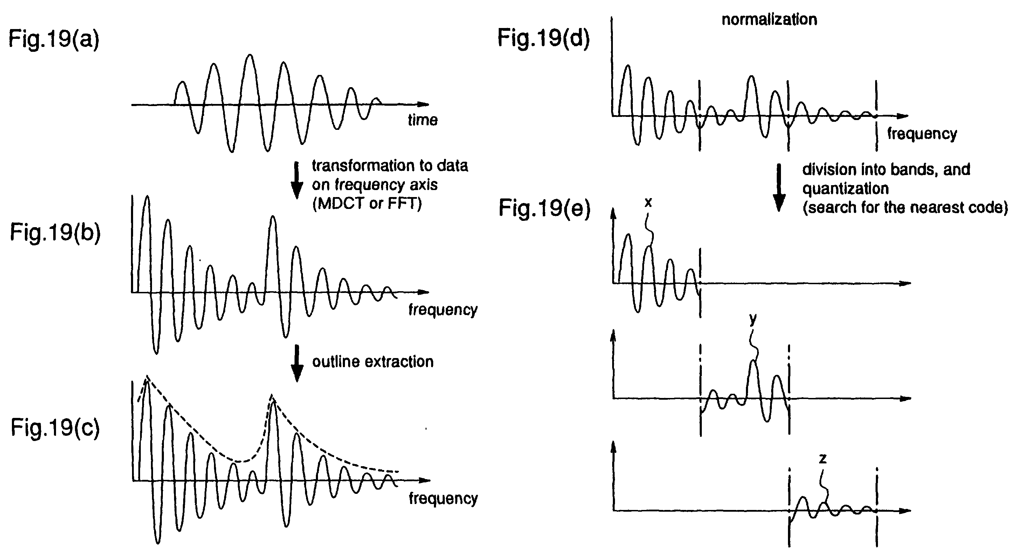

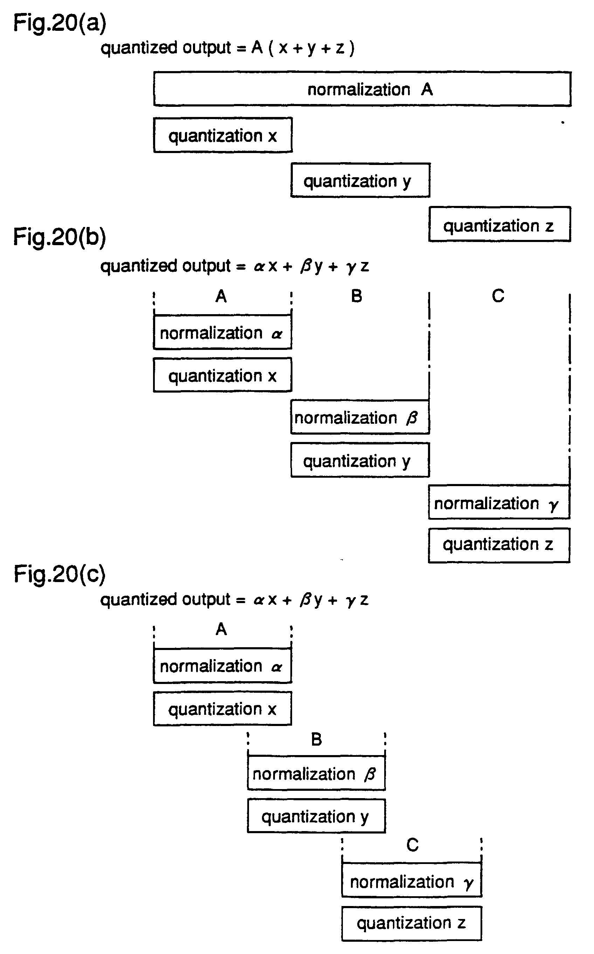

In the structure having a normalization means in an audio signal coding apparatus according to any of the first to third embodiments, as shown in figure 19(a), an audio signal waveform on the time axis is transformed to a waveform on the frequency axis by MDCT, FFT, and the normalization means performs normalization A, i.e., outline extraction and division of the extracted outline by an amplitude value, for the entire frequency domain of the waveform on the frequency axis as shown in figure 20(a). Thereafter, the normalized output is subjected to quantization x,y,z for each of three frequency domains, i.e., low-band, intermediate-band, and high-band which are obtained by dividing the entire frequency domain, respectively, whereby a quantized output, A(x+y+z), is obtained.

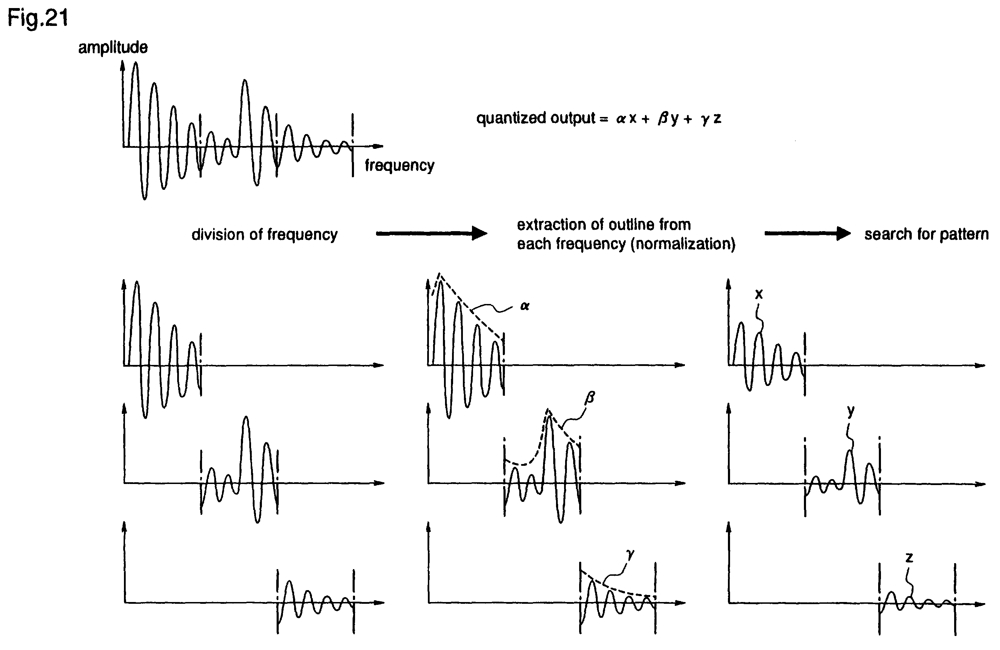

On the other hand, in this fifth embodiment, as shown in figure 20(b), normalization means $\alpha$, $\beta$, and $\gamma$ are placed before the divided quantization means, respectively, and initially, as shown in figure 19(d), a waveform on the frequency axis is divided into a plurality of frequency bands. Thereafter, normalization and quantization are performed for each of the frequency bands and, as the result, a quantized output, $\alpha x + \beta y + \gamma z$, is obtained. The entire process is shown in figure 21.

Generally, when there is a considerable polarization of frequency characteristics of an audio signal, for example, when it is a signal of which frequency concentrates in the low-band like voice information, if this signal is entirely and roughly normalized, a characteristic portion in the low band cannot be preponderantly normalized and quantized. Namely, the entire and rough normalization does not take an envelope of a portion of the signal where the signal change is small, so that data in the portion where the signal change is small are lost. Therefore, when quantization is performed after such normalization, even though the quantizer exhibits its full ability, it merely performs quantization to the signal which does not have data in the portion where the signal change is small, i.e., it performs meaningless quantization. In other words, the quantizer performs quantization in which the effect by the normalization and the quantization combined is hardly obtained. As long as a normalization means is provided, it is desirable that both of the normalization means and the quantization means exhibit their full abilities. In contrast with this, when a very rough signal is input, even though all of this signal is roughly normalized, the result does not differ very much.

Figure 20(a) shows the relationship between the normalization means and each quantization means in the audio signal coding apparatus having the normalization unit 104 shown in figure 1, according to any of the first to third embodiments. In such structure that the normalization means A normalizes the whole of frequency characteristic signal sequence of an input audio signal, when the input audio signal is a signal having a polarization with respect to frequency, for example, a signal of which frequency concentrates in the low-band, both of the normalization means and the quantization means cannot exhibit their full abilities.

In contrast with this, in the structure according to the fifth embodiment wherein the quantization means x, y, and z are provided with the previous-stage normalization means $\alpha$, $\beta$, and $\gamma$, since normalization is carried out for each object signal to be quantized by each quantization means, each normalization means performs appropriate normalization with regard to the load of each quantization means which performs quantization, i.e., normalization in which the level of signal to be quantized is brought to the level at which each quantization means can exhibit its full ability, whereby the maximum effect by the normalization means and the quantization means combined is provided.

To be specific, the structures of the normalization unit and the quantization unit in the coding apparatus according to the fifth embodiment are as shown in figure 20(b). Initially, for a coefficient stream in a frequency band A which is obtained by dividing a frequency characteristic signal sequence obtained by frequency transformation of an input audio signal or by dividing the frequency band of the frequency characteristic signal sequence, normalization and quantization are performed by the first-stage normalization means a and quantization means x. Then, by the second-stage normalization means $\beta$ and quantization means y, a coefficient stream in a frequency band B adjacent to the coefficient stream of the first-stage frequency band A is subjected to normalization and quantization. Further, by the third-stage normalization means γ and quantization means z, a coefficient stream in a frequency band C adjacent to the coefficient stream of the frequency band B is subjected to normalization and quantization.

Alternatively, as shown in figure 20(c), the second-stage normalization means β and quantization means y perform normalization and quantization for the frequency band B which is adjacent to and partially overlapped with the first-stage frequency band A so that the quantization error output from the first stage is normalized and quantized in the overlapped portion while the coefficient stream of the frequency band B of the frequency characteristic signal sequence is normalized and quantized in the other portion; and the third-stage normalization means γ and quantization means z perform normalization and quantization for the frequency band C which is adjacent to and partially overlapped with the second-stage frequency band B so that the quantization error output from the second stage is normalized and quantized in the overlapped portion while the coefficient stream of the frequency band C of the frequency characteristic signal sequence is normalized and quantized in the other portion.

In the structure shown in figure 20(b) or 20(c), since normalization is carried out before each quantization by each quantization means, each normalization means performs normalization with regard to the load of each quantization means, whereby each normalization means and each quantization means can perform quantization while exhibiting their full abilities, resulting in significantly improved quantization efficiency.

The frequency bands processed by the normalization and quantization means in the respective stages and the quantization depths are not restricted to those shown in figures 20(b) and 20(c). These bands and depths may be adjusted arbitrarily.

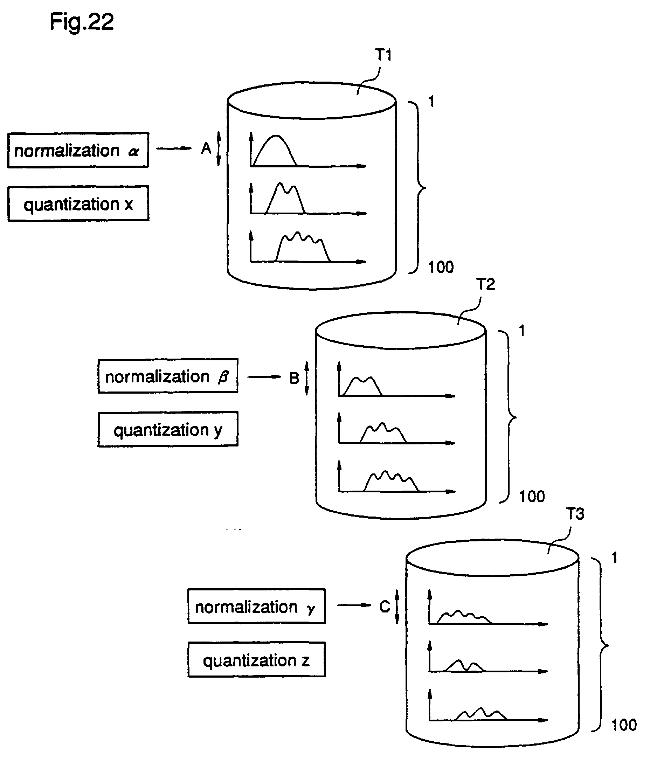

Next, a description is given of an example of normalization and quantization method by the first-stage to third-stage normalization and quantization means, using figures 18 and 22.

In this fifth embodiment, although the first, second, and third normalization units 1801, 1804, and 1807 are implemented by the same structure as the normalization unit 104 according to the first embodiment, these units may be implemented using a normalization parameter calculating method other than mentioned above. For example, the normalization units may be constructed using, as normalization parameters, LPC coefficients or LSP coefficients directly calculated from MDCT coefficients input to the respective normalization units. In figure 22, T1, T2, and T3 are tables for normalization used by the respective normalization means α, β, and γ, and these tables are obtained in the following manner.

For MDCT coefficients of various kinds of sound source signals which can be input as an input audio signal, LPC (Linear Predictive Coding) analysis is performed to obtain LSP (Line Spectrum Pair) coefficients. This operation is repeated for each sound source, and LSP coefficients are obtained for all frames. Then, all the LSP coefficients are collected and subjected to cluster analysis to obtain a plurality of representative envelope patterns, and these envelope patterns are used as the normalization table T1 for the first-stage normalization means α.

Using the plural envelope patterns so obtained, first-stage normalization and quantization are carried out, and the output from the first stage is subjected to the same process as the above-described process from the LPC analysis to obtain a plurality of envelope patterns, and these envelope patterns are used as the normalization table T2 for the second-stage normalization means β.

Thereafter, the normalization table T3 for the third-stage normalization means γ is obtained in the same manner as described above.

In this way, the normalization tables T1, T2, and T3 for the normalization means are obtained, which tables enables the respective quantization means in the first to third stages to perform optimum quantization in which normalization and quantization exhibit their full abilities, with regard to the load of each quantization means.

In the audio signal coding apparatus so constructed, when an audio signal, which can be considered as being composed of various kinds of sound source signals, is input to this apparatus, the input audio signal is transformed from data on the time axis to data on the frequency axis by MDCT, FFT, as shown in figures 19(a) through 19(b). The signal transformed to the data on the frequency axis is subjected to outline extraction as shown in figures 19(b) through 19(c). This outline extraction is performed using the normalization table T1 of the first-stage normalization means α, and an outline obtained as the result is made of, for example, about 20 pieces of LSP polynomials. Then, the signal transformed to the data on the frequency axis is divided by the obtained outline, whereby normalization α is performed. After the normalization, the normalized signal is quantized by the quantization means x, thereby completing the first-stage normalization and quantization. As a result, efficient quantization is performed with regard to the features of the various kinds of sound source signals described above.

Next, by the second-stage normalization and quantization means, second-stage normalization and quantization are performed to a coefficient stream of a frequency band B different from a coefficient stream of a frequency band A which is divided from a frequency characteristic signal sequence and subjected to the first-stage normalization and quantization, or to a quantization error output as a result of the first-stage normalization and quantization, using the second-stage normalization table T2. Thereby, efficient quantization is performed with regard to the features of various kinds of sound source signals described above, giving priority to a desired frequency band or to a quantization depth of a desired frequency band portion.

Furthermore, by the third-stage normalization and quantization means, third-stage normalization and quantization are performed to a coefficient stream of a frequency band different from coefficient streams of frequency bands divided from the frequency characteristic signal sequence and subjected to the first-stage and second-stage normalization and quantization, or to a quantization error output as a result of the second-stage normalization and quantization, using the third-stage normalization table T3. Thereby, efficient quantization is performed with regard to the features of various kinds of sound source signals described above, giving priority to a desired frequency band or to a quantization depth of a desired frequency band portion.

As described above, since the normalization $\alpha$ and quantization x, the normalization $\beta$ and quantization y, and the normalization $\gamma$ and quantization z in the respective stages are carried out using the normalization table T1, T2, and T3 which are created by the above-described method, it is possible to perform normalization that reduces excessive burden on quantization, according to the characteristic of the object signal to be quantized, whereby the quantization efficiency is significantly improved and the quality at the reproduction end is significantly improved.

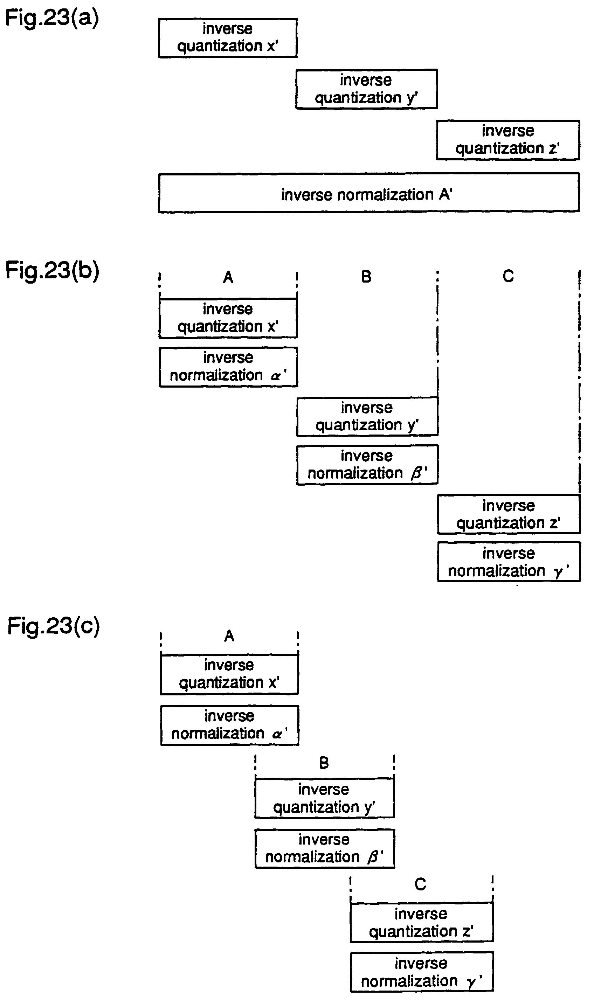

Furthermore, the structure of a decoding apparatus corresponding to the coding apparatus according to the fifth embodiment is shown in figures 23(b) and 23(c). Corresponding to the structure of the coding apparatus shown in figures 20(b) and 20(c), it is provided with inverse quantization units x', y', and z' which receive signals output from the respective quantizers of the quantization unit of the audio signal coding apparatus, and reproduce signals corresponding to the coefficient streams of the respective frequency bands into which the frequency characteristic signal sequence is divided; a plurality of inverse normalization units $\alpha$', $\beta$', and $\gamma$' which are provided for the respective inverse quantization units, multiply the coefficient streams of the frequency characteristic signal sequence output from the inverse quantization units by normalized components which are reproduced on the basis of codes relating to normalization output from the audio signal coding apparatus, and output signals corresponding to the respective coefficient streams of the frequency characteristic signal sequence before being coded; and an inverse frequency transformation unit (not shown) which receives the outputs from the respective inverse normalization units and outputs a signal corresponding to the original audio signal.

Moreover, when the inverse normalization and inverse quantization in the decoding apparatus are performed directed to, alternately, extending the band to be quantized and increasing the depth of quantization, as described for the fourth embodiment, a desired quantity of data of the coded audio signal can be decoded regardless of the quantity of data transmitted from the coding apparatus. That is, the quantity of data to be decoded can be varied according to the communication environment or the like on the receiving end, and high-definition sound quality can be obtained stably even when an ordinary public telephone network is used.

In this fifth embodiment, each of the first, second, and third quantization band selection units 1803, 1806, and 1809 may be constructed so that it outputs a frequency band to be quantized that is set in advance. In this case, in each of the first, second, and third quantization band selection units 1803, 1806, and 1809, calculation to obtain a band to be quantized is not executed and a previously set frequency band to be quantized is output, whereby the structure is simplified.

Furthermore, each of the first, second, and third quantization band selection units 1803, 1806, and 1809 may be constructed so that it performs band selection using two characteristics, i.e., the minimum audible characteristic in silence and the masking characteristic which makes sounds of frequency components in the vicinity of a specific input frequency component inaudible, in order to obtain, as an output, a frequency band to be quantized, on the basis of the auditive characteristic of human beings.

According to the audio signal coding apparatus of the fifth embodiment, a normalization means is provided before each of quantization means performing multiple-stage quantization, and normalization is performed for each of divided frequencies and for each stage of quantization, followed by quantization. Therefore, normalization for each frequency domain enables appropriate coding according to the quantity of data possessed by the audio signal in each frequency domain, that is, the normalization means and the quantization means perform coding while exhibiting their full abilities, whereby quantization of high efficiency is performed without losing the data quantity possessed by the original audio signal and, therefore, with less quantization error, with the result that high-definition sound quality is obtained stably.

In the first to fifth embodiments, the multiple-stage quantization means has, at least, a first-stage vector quantizer for vector-quantizing the frequency characteristic signal sequence or a portion thereof, and a second-stage vector quantizer for vector-quantizing a quantization error component from the first-stage vector quantizer; and each stage of the multiple-stage quantization means is provided with at least one divided vector quantizer which vector-quantizes a coefficient stream of any of plural frequency bands which are obtained by dividing the frequency characteristic signal sequence into at least two frequency bands which may have an overlapped portion between the plural stages, according to a division manner for each stage. However, each quantization means of the multiple-stage quantization means may be an entire-band vector quantizer that vector-quantizes all of the entire frequency characteristic signal sequence or all of quantization error components from the previous-stage quantization means. Even when multiple-stage quantization is carried out by the entire-band vector quantizer to code an audio signal at a low bit rate, i.e., at a high compression ratio as described above, or even though coding and decoding are carried out without a fixed data quantity, a high-definition sound can be reproduced at the receiving end.

As described above, according to the audio signal coding apparatus, and decoding apparatus, or coding and decoding method of the present invention, provided for quantization is a structure capable of performing quantization even at a high data compression ratio by using, for example, a vector quantization method, and employed for allocation of data quantity during quantization is to allocate, alternately, data quantity contributing to expansion of a reproduced band and data quantity contributing to improvement of quality. First of all, in the coding apparatus, as the first stage, an input audio signal is transformed to a signal in the frequency domain, and a portion of the frequency signal is coded; in the second stage, a portion of the frequency signal uncoded and a quantization error signal in the first stage are coded and added to the codes obtained in the first stage; in the third stage, the other portion of the frequency signal uncoded, and quantization error signals in the first and second stages are coded and added to the codes obtained in the first and second stages; followed by similar coding in forward stages. On the other hand, in the decoding apparatus, any of the following decoding manners is possible: decoding using only the codes coded in the first stage, decoding using the codes decoded in the first and second stages, and decoding using the codes decoded in stages from the first stage to the third or more stage. The decoding order is to decode, alternately, codes contributing to band expansion and codes contributing to quality improvement. Therefore, satisfactory sound quality is obtained even though coding and decoding are carried out without a fixed data quantity. Further, a high-quality sound is obtained at a high compression ratio.

Furthermore, according to the audio signal coding apparatus, and decoding apparatus, or coding and decoding method of the present invention, a normalization means is provided before the quantization means, and normalization of an input audio signal is carried out before quantization. Therefore, the normalization means and the quantization means perform coding while exhibiting their full abilities, whereby highly efficient quantization is carried out without losing the data quantity possessed by the original audio signal and, therefore, with less quantization error, and the effect is dramatically heightened according to the kind of the audio signal. Furthermore, as described above, allocation of data quantity during quantization is carried out so as to allocate, alternately, data quantity contributing to expansion of a reproduced band and data quantity contributing to improvement of quality. When the data quantity at the receiving end is limited, inverse quantization is carried out only in a narrow band and a shallow region. However, by expanding the inverse quantization alternately in the direction to broaden the band and the direction to increase the depth of the inverse quantization to increase the data quantity at the receiving end, a desired quantity of data of the coded audio signal can be decoded regardless of the quantity of data transmitted from the coding apparatus. Accordingly, by varying the quantity of data to be decoded according to the communication environment or the like on the receiving end, high-definition sound quality can be obtained stably even when an ordinary public telephone network is used.

Furthermore, according to the audio signal coding apparatus, and decoding apparatus, or coding and decoding method of the present invention, a normalization means is provided before each of quantization means performing multiple-stage quantization, and normalization is performed for each of divided frequencies and for each stage of quantization, followed by quantization. Therefore, normalization for each frequency domain enables appropriate coding according to the quantity of data possessed by the audio signal in each frequency domain, that is, the normalization means and the quantization means perform coding while exhibiting their full abilities, whereby quantization of high efficiency is performed without losing the data quantity possessed by the original audio signal and, therefore, with less quantization error, with the result that high-definition sound quality is obtained stably, and the effect is dramatically heightened according to the kind of the audio signal. Further, at the decoding end, when inverse normalization and inverse quantization are carried out in both of the direction to broaden the quantization band and the direction to increase the quantization depth, alternately, a desired quantity of data of the coded audio signal can be decoded regardless of the quantity of data transmitted from the coding apparatus. Accordingly, by varying the quantity of data to be decoded according to the communication environment or the like on the receiving end, high-definition sound quality can be obtained stably even when an ordinary public telephone network is used.

Applicability in Industry

As described above, according to audio signal coding apparatus, and decoding apparatus, or coding and decoding method of the present invention, even though coding and decoding are carried out without a fixed data quantity, satisfactory sound quality is obtained and, further, a high-quality sound is obtained at a high compression ratio.

Furthermore, normalization for each frequency band enables appropriate coding according to the data quantity possessed by the audio signal in each frequency band, whereby normalization means and quantization means perform coding while exhibiting their full abilities, and highly efficient quantization is carried out without losing the data quantity possessed by the original audio signal and, therefore, with less quantization error. This effect is dramatically heightened according to the kind of the audio signal. Accordingly, by varying the quantity of data to be decoded according to the communication environment or the like on the receiving end, high-definition sound quality can be obtained stably even when an ordinary public telephone network is used.

**Claims**

1. An audio signal coding apparatus for coding an audio signal by performing vector quantization to a frequency characteristic signal sequence which is obtained by subjecting an input audio signal to frequency transformation, comprising:

   multiple-stage quantization means comprising, at least, a first-stage vector quantizer for vector-quantizing the frequency characteristic signal sequence or a portion thereof, and a second-stage vector quantizer for vector-quantizing a quantization error component generated by the first-stage vector quantizer; and
   each quantization means in each stage of the multiple-stage quantization means having at least one divided vector quantizer which vector-quantizes a coefficient stream in any of plural frequency bands obtained by dividing the frequency characteristic signal sequence into, at least, two frequency bands which can have an overlapped portion between the plural stages, using a division manner for each stage.

2. An audio signal coding apparatus as defined in Claim 1 further comprising a normalization means for normalizing the frequency characteristic signal sequence, and adding its output to the multiple-stage quantization means.

3. An audio signal coding apparatus as defined in any of Claims 1 and 2, wherein said quantization means in each stage appropriately selects, as a frequency band divided from the frequency characteristic signal sequence to be quantized, a band having a large energy-addition-sum of the quantization error, and quantizes the selected band.

4. An audio signal coding apparatus as defined in any of Claims 1 and 2, wherein said quantization means in each stage selects a frequency band, as a frequency band divided from the frequency characteristic signal sequence to be quantized, on the basis of the auditive sensitivity characteristic showing the auditive nature of human beings, and quantizes the selected band, which frequency band selected has a large energy-addition-sum of a quantization error weighted by giving a large value to a band having a high importance of the auditive sensitivity characteristic.

5. An audio signal coding apparatus as defined in any of Claims 1 to 4 further comprising:

   a first quantization band selection unit between the first-stage vector quantizer and the second-stage vector quantizer which are constituents of the multiple-stage quantization means; and
   a second quantization band selection unit between the second-stage vector quantizer and the third-stage vector quantizer;
   wherein said first quantization band selection unit receives, as an input, the quantization error output from the first-stage vector quantizer, and selects a band to be quantized by the second-stage vector quantizer; and
   said second quantization band selection means receives, as an input, the quantization error output from the second-stage vector quantizer, and selects a band to be quantized by the third-stage vector quantizer.

6. An audio signal coding apparatus as defined in Claim 5 wherein said multiple-stage quantization means comprises:

   a plurality of i-th stage divided vector quantizers which quantize, independently, the respective coefficient streams in the respective frequency bands into which the frequency characteristic signal sequence is divided; and
   a j-th stage vector quantizer which serves as an entire-band quantizer for quantizing, once at least, all of the respective frequency bands of the input signal to be quantized.

7. An audio signal coding apparatus as defined in Claim 1 wherein, in said multiple-stage quantization means, the previous-stage vector quantizer calculates a quantization error in vector quantization using a vector quantization method with a code book, and the subsequent-stage vector quantizer performs further vector quantization to the calculated quantization error.

8. An audio signal coding apparatus as defined in Claim 2 wherein, in said multiple-stage quantization means, the previous-stage vector quantizer calculates a quantization error in vector quantization using a vector quantization method with a code book, and the subsequent-stage vector quantizer performs further vector quantization to the calculated quantization error.

9. An audio signal coding apparatus as defined in Claim 8 wherein, when calculating distances between codes used for retrieving an optimum code in the code book during vector quantization, the vector quantizer in the multiple-stage quantization means calculates the distances using, as weights, normalized components of the input signal output from the normalization means, and extracts a code having a minimum distance.

10. An audio signal coding apparatus as defined Claim 9, wherein the vector quantizer in the multiple-stage quantization means calculates the distances using, as weights, both of the normalized component of the frequency characteristic signal sequence output from the normalization means and a value in view of the auditive characteristic showing the auditive nature of human beings, and extracts a code having a minimum distance.

11. An audio signal coding apparatus as defined in any of Claims 2 and 8~10, wherein said normalization means is provided with a frequency outline normalization unit which roughly normalizes the outline of the frequency characteristic signal sequence.

12. An audio signal coding apparatus as defined in any of Claims 2 and 8~10, wherein said normalization means is provided with a band amplitude normalization unit which divides the frequency characteristic signal sequence into a plurality of components of continuous unit frequency bands, and normalizes the coefficient stream in each unit band by dividing it with a single value.

13. An audio signal coding apparatus as defined in Claim 1, wherein said multiple-stage quantization means comprises:

a vector quantizer which quantizes the respective coefficient streams of the respective frequency bands into which the frequency characteristic signal sequence is divided, independently by divided vector quantizers; and
a vector quantizer which serves as an entire-band quantizer for quantizing, once at least, all of the respective frequency bands of the input signal to be quantized.

14. An audio signal coding apparatus as defined in Claim 13, wherein said multiple-stage quantization means comprises:

a first vector quantizer comprising a low-band divided vector quantizer, an intermediate-band divided vector quantizer, and a high-band divided vector quantizer;
a second vector quantizer connected after the first vector quantizer; and
a third vector quantizer connected after the second vector quantizer;
wherein a frequency characteristic signal sequence input to the multiple-stage quantization means is divided into three bands, and the frequency characteristic signal sequence of low-band component among the three bands is quantized by the low-band divided vector quantizer, the frequency characteristic signal sequence of intermediate-band component among the three bands is quantized by the intermediate-band divided vector quantizer, and the frequency characteristic signal sequence of high-band component among the three bands is quantized by the high-band divided vector quantlzer, independently;
each of the divided vector quantizers constituting the first vector quantizer calculates a quantization error with respect to the frequency characteristic signal sequence, and outputs this error toward the subsequent second vector quantizer;
said second vector quantizer performs quantization for a band width to be quantized by the second vector quantizer, calculates a quantization error with respect to the input to the second vector quantizer, and outputs this error toward the third vector quantizer; and
said third vector quantizer performs quantization for a band width to be quantized by the third vector quantizer.

15. An audio signal coding apparatus as defined in Claim 14 further comprising:

a first quantization band selection unit disposed between the first vector quantizer and the second vector quantizer which are constituents of the multiple-stage quantization means, and a second quantization band selection unit disposed between the second vector quantizer and the third vector quantizer;
wherein said first quantization band selection unit receives, as an input, the output from the first vector quantizer, and selects a band to be quantized by the second vector quantizer;
said second vector quantizer performs quantization for a band width to be quantized by the second vector quantizer, with respect to the quantization errors from the first vector quantizer comprising the three vector quantizers, in the band selected by the first quantization band selection unit, calculates a quantization error with respect to the input to the second vector quantizer, and outputs this error toward the second quantization band selection unit;

said second quantization band selection unit receives, as an input, the quantization error from the second vector quantizer, and selects a band to be quantized by the third vector quantizer; and

said third vector quantizer performs quantization for a band width to be quantized by the third vector quantizer, with respect to the quantization error from the second vector quantizer in the band selected by the second quantization band selection unit.

16. An audio signal coding apparatus as defined in Claim 14 wherein, in place of the first vector quantizer, the second vector quantizer or the third vector quantizer is constructed using the low-band divided vector quantizer, the intermediate-band divided vector quantizer, and the high-band divided vector quantizer.

17. An audio signal decoding apparatus receiving, as an input, codes output from the audio signal coding apparatus defined in Claim 1, and decoding these codes to output a signal corresponding to the original input audio signal, comprising:

an inverse quantization unit for performing inverse quantization using at least a portion of the codes output from the quantization means of the audio signal coding apparatus; and
an inverse frequency transformation unit for transforming a frequency characteristic signal sequence output from the inverse quantization unit to a signal corresponding to the original audio input signal.

18. An audio signal decoding apparatus receiving, as an input, codes output from the audio signal coding apparatus defined in Claim 2, and decoding these codes to output a signal corresponding to the original input audio signal, comprising:

an inverse quantization unit for reproducing a frequency characteristic signal sequence;
an inverse normalization unit for reproducing normalized components on the basis of the codes output from the audio signal coding apparatus, using the frequency characteristic signal sequence output from the inverse quantization unit, and multiplying the frequency characteristic signal sequence and the normalized components; and
an inverse frequency transformation unit for receiving the output from the inverse normalization unit and transforming the frequency characteristic signal to a signal corresponding to the original audio signal.

19. An audio signal decoding apparatus receiving, as an input, codes output from the audio signal coding apparatus defined in Claim 13, and decoding these codes to output a signal corresponding to the original input audio signal, comprising:

an inverse quantization unit which performs inverse quantization using the output codes whether the codes are output from all of the vector quantizers constituting the quantization means in the audio signal coding apparatus, or from some of them.

20. An audio signal decoding apparatus as defined in Claim 19, wherein:

subsequent to inverse quantization of quantized codes in a prescribed band in a specific stage, said inverse quantization unit executes, alternately, inverse quantization of quantized codes in the prescribed band in a next stage, and inverse quantization of quantized codes in a band different from the prescribed band in the specific stage;
when there are no quantized codes in the prescribed band in the next stage, the inverse quantization unit continuously executes inverse quantization of quantized codes in another different band; and
when there are no quantized codes in the band different from the prescribed band, the inverse quantization unit continuously executes inverse quantization of quantized codes in a next stage.

21. An audio signal decoding apparatus receiving, as an input, codes output from the audio signal coding apparatus defined in Claim 14, and decoding these codes to output a signal corresponding to the original input audio signal, comprising:

an inverse quantization unit which performs inverse quantization using only codes output from the low-band divided vector quantizer as a constituent of the first vector quantizer even though all or some of the three divided vector quantizers constituting the first vector quantizer in the audio signal coding apparatus output codes.

22. An audio signal decoding apparatus as defined in Claim 21, wherein said inverse quantization unit performs inverse quantization using codes output from the second vector quantizer, in addition to the codes output from the low-band divided vector quantizer as a constituent of the first vector quantizer.

23. An audio signal decoding apparatus as defined in Claim 22, wherein said inverse quantization unit performs inverse quantization using codes output from the intermediate-band divided vector quantizer as a constituent of the first vector quantizer, in addition to the codes output from the low-band divided vector quantizer as a constituent of the first vector quantizer and the codes output from the second vector quantizer.

24. An audio signal decoding apparatus as defined in Claim 23, wherein said inverse quantization unit performs inverse quantization using codes output from the third vector quantizer, in addition to the codes output from the low-band divided vector quantizer as a constituent of the first vector quantizer, the codes output from the second vector quantizer, and the codes output from the intermediate-band divided vector quantizer as a constituent of the first vector quantizer.

25. An audio signal decoding apparatus as defined in Claim 24, wherein said inverse quantization unit performs inverse quantization using codes output from the high-band divided vector quantizer as a constituent of the first vector quantizer, in addition to the codes output from the low-band divided vector quantizer as a constituent of the first vector quantizer, the codes output from the second vector quantizer, the codes output from the intermediate-band divided vector quantizer as a constituent of the first vector quantizer, and the codes output from the third vector quantizer.

26. An audio signal coding and decoding method receiving a frequency characteristic signal sequence obtained by frequency transformation of an input audio signal, coding and outputting this signal, and decoding the output coded signal to reproduce a signal corresponding to the original input audio signal, wherein:

the frequency characteristic signal sequence is divided into coefficient streams corresponding to at least two frequency bands, and these coefficient streams are independently quantized and output; and
from the quantized signal received, data of an arbitrary band corresponding to the divided band are inversely quantized, thereby to reproduce a signal corresponding to the original input audio signal.

27. An audio signal coding and decoding method as defined in Claim 26, wherein:

said quantization is performed by stages so that a calculated quantization error is further quantized; and
said inverse quantization is performed by repeating, alternately, quantization directed at expanding the band, and quantization directed at deepening the quantization stages at the quantization.

28. An audio signal coding and decoding method as defined in Claim 27, wherein said inverse quantization directed at expanding the band is carried out by extending the band in the order with regard to the auditive psychological characteristic of human beings.

29. An audio signal coding and decoding method as defined in any of Claims 26 to 28 wherein:

at the coding end, after the frequency characteristic signal sequence is normalized, the frequency characteristic signal sequence is divided into coefficient streams corresponding to at least two frequency bands, and the respective coefficient streams are independently quantized and output; and
at the decoding end, using the codes relating to normalization from the coding end, the codes from the coding end is subjected to inverse normalization and, thereafter, the inversely normalized codes are subjected to inverse quantization so that data in an arbitrary band corresponding to the divided band are inversely quantized, thereby to reproduce a signal corresponding to the original audio input signal.

30. An audio signal coding apparatus for coding an audio signal by performing normalization and vector quantization to a frequency characteristic signal sequence which is obtained by subjecting an input audio signal to frequency transformation, comprising:

multiple-stage quantization means comprising, at least, a first-stage normalization and vector-quantization unit which normalizes and vector-quantizes the frequency characteristic signal sequence or a portion thereof, and a second-stage normalization and vector-quantization unit which normalizes and vector-quantizes a quantization error component generated by the first-stage vector-quantization unit; and

each quantization means in each stage of the multiple-stage quantization means having at least one divided normalization and vector-quantization unit which normalizes and vector-quantizes a coefficient stream of any of plural frequency bands obtained by dividing the frequency characteristic signal sequence into, at least, two frequency bands which can have an overlapped portion between the plural stages, using a division manner for each stage.

**31.** An audio signal coding apparatus as defined in Claim 30 further comprising:

a first quantization band selection unit between the first-stage normalization and vector-quantization unit and the second-stage normalization and vector-quantization unit which are constituents of the multiple-stage quantization means; and

a second quantization band selection unit between the second-stage normalization and vector-quantization unit and a third-stage normalization and vector-quantization unit;

wherein said first quantization band selection unit receives, as an input, the quantization error output from the first-stage normalization and vector-quantization unit, selects a band to be quantized by the second-stage normalization and vector-quantization unit, and outputs a quantization error in the selected band toward the second-stage normalization and vector-quantization unit; and

said second quantization band selection means receives, as an input, the quantization error output from the second-stage normalization and vector-quantization unit, selects a band to be quantized by the third-stage normalization and vector-quantization unit, and outputs a quantization error in the selected band toward the third-stage normalization and vector-quantization unit.

**32.** An audio signal coding apparatus as defined in Claim 31, wherein each of the normalization and vector-quantization units in and after the second stage of the multiple-stage quantization means appropriately selects a frequency band having a large energy-addition-sum of the quantization error output from the previous-stage normalization and vector-quantization unit, from the frequency bands divided from the frequency characteristic signal sequence to be normalized and quantized, and then the unit normalizes and quantizes the selected band.

**33.** An audio signal coding apparatus as defined in Claim 31, wherein each of the normalization and vector-quantization units in and after the second stage of the multiple-stage quantization means appropriately selects a frequency band from the frequency bands divided from the frequency characteristic signal sequence to be normalized and quantized, on the basis of the auditive sensitivity characteristic showing the auditive nature of human beings, which frequency band selected has a large energy-addition-sum of the quantization error that is output from the previous-stage normalization and vector-quantization unit and weighted by giving a large value to a band having a high importance of the auditive sensitivity characteristic, and then the unit normalizes and quantizes the selected band.

**34.** An audio signal decoding apparatus receiving, as an input, codes output from an audio signal coding apparatus as defined in any of Claims 30 to 33, and decoding the codes to output a signal corresponding to the original input audio signal, comprising:

inverse quantization units for receiving signals from the respective quantizers of the quantization unit in the audio signal coding apparatus, and reproducing signals corresponding to the coefficient streams of the respective frequency bands into which the frequency characteristic signal sequence is divided;

a plurality of inverse normalization units provided correspondingly to the respective inverse quantization units, for multiplying the coefficient streams of the frequency characteristic signal sequence output from the respective inverse quantization units by normalized components reproduced on the basis of the codes relating to normalization and output from the audio signal coding apparatus, and outputting signals corresponding to the respective coefficient streams of the frequency characteristic signal sequence before being coded; and

an inverse frequency transformation unit for receiving the outputs from the plural inverse normalization units, and transforming them to a signal corresponding to the original audio signal.

**35.** An audio signal coding and decoding method receiving a frequency characteristic signal sequence obtained by frequency transformation of an input audio signal, coding and outputting this signal, and decoding the output coded signal to reproduce a signal corresponding to the original input audio signal, wherein:

the frequency characteristic signal sequence is divided into coefficient streams corresponding to at least two frequency bands, and these coefficient streams are independently normalized, quantized, and output; and

from the quantized signal received, using the codes relating to normalization and output from the coding end, data of an arbitrary band corresponding to the divided band are inversely normalized and quantized, thereby to reproduce a signal corresponding to the original input audio signal.

**36.** An audio signal coding and decoding method as defined in Claim 35, wherein:

said normalization and quantization are carried out by stages so that the calculated quantization errors are further normalized and quantized; and
said inverse normalization and quantization are carried out by repeating, alternately, inverse normalization and quantization directed at extending the band, and inverse normalization and quantization directed at deepening the quantization stages at the quantization.

**37.** An audio signal coding and decoding method as defined in Claim 36, wherein said inverse normalization and quantization directed at extending the band is performed by extending the band in the order in view of the auditive psychological characteristic of human beings.

**38.** An audio signal coding apparatus for coding an audio signal by performing vector quantization to a frequency characteristic signal sequence which is obtained by subjecting an input audio signal to frequency transformation, comprising:

multiple-stage quantization means comprising, at least, a first-stage vector quantizer for vector-quantizing the frequency characteristic signal sequence, and a second-stage vector quantizer for vector-quantizing a quantization error component generated by the first-stage vector quantizer; and
each quantization means in each stage of the multiple-stage quantization means comprising an entire-band vector quantizer for vector-quantizing all of the frequency characteristic signal sequence or all of the quantization error components output from the previous-stage quantization means.

Fig.1

## Fig.2

from frame division unit 101

MDCT coefficients

frequency outline
normalization unit — 201

band amplitude
normalization unit — 202

band table — 203

indices IND$_1$        to quantization
unit 105

## Fig.3

MDCT coefficients

from frame division unit 101

201

linear prediction
analysis unit

302        301        303

outline
quantization unit

envelope characteristic
normalization unit

index IND$_1$        to band amplitude
normalization unit 202

# Fig.4

# Fig.5

## Fig.6

601 first sub-quantization unit

602 first quantized band selection unit

603 second sub-quantization unit

604 second quantized band selection unit

605 third sub-quantization unit

indices $IND_2$

## Fig.7

index of normalization unit 104

index of first sub-quantization unit (low band)

to inverse normalization unit 107

$IND_1$

$IND_{21}$

701

first inverse quantization unit low band

$IND_{21'}$

inverse quantization unit 106

output from inverse quantization unit (MDCT coefficients)

# Fig.8

index of normalization unit

index of first sub-quantization unit (low band)

index of second sub-quantization unit

to inverse normalization unit 107 ← $IND_1$

$IND_{21}$

701 — first inverse quantization unit low band

$IND_{21'}$

⊕ addition

704 — second inverse quantization unit ← $IND_3$

inverse quantization unit 106

$IND_{3'}$

output from inverse quantization unit (MDCT coefficients)

## Fig.9

| index of normalization unit | index of first sub-quantization unit (low band) | index of second sub-quantization unit | index of first sub-quantization unit (intermediate band) |
|---|---|---|---|

to inverse normalization unit ← 107    $IND_1$    $IND_{21}$    $IND_{22}$

702

701   | first inverse quantization unit low band | first inverse quantization unit intermediate band |

$IND_3$

$IND_{21'}$

⊕ addition

704   second inverse quantization unit

inverse quantization unit 106

$IND_{3'}$    $IND_{22'}$

output from inverse quantization unit (MDCT coefficients)

## Fig.10

## Fig.11

to inverse
normalization unit ←— $IND_1$
107

index of normalization unit

index of first sub-quantization unit (low band)

index of second sub-quantization unit

index of first sub-quantization unit (intermediate band)

index of third sub-quantization unit

index of first sub-quantization unit (high band)

$IND_{21}$  $IND_{22}$  $IND_{23}$

702  703

701

| first inverse quantization unit low band | first inverse quantization unit intermediate band | first inverse quantization unit high band |

$IND_{21'}$

⊕ addition

704

second inverse quantization unit

$IND_3$  $IND_4$

$IND_{3'}$

⊕ addition

705

third inverse quantization unit

$IND_{22'}$  $IND_{23'}$

inverse quantization unit 106

$IND_{4'}$

output from inverse quantization unit (MDCT coefficients)

## Fig.12

from inverse
quantization unit 106

frequency outline
inverse normalization unit ⟋1201

IND$_{11}$ IND$_{12}$

band amplitude
inverse normalization unit ⟋1202

band table ⟋1203

indices
IND$_1$

to inverse
MDCT unit 108

## Fig.13

1401

1402

| MDCT in a quantized band of a sub-quantization unit |
|---|

| normalized components in the same quantized band |
|---|

| sound source sub-vector | ~ 1403

| weight sub-vector | ~ 1404

1409

| vector quantizer | ~ 1405 |
|---|
| distance calculation means | ~ 1406 |
| code decision means | ~ 1407 |
| residual generation means | ~ 1408 |

code vectors

code book

| residual sub-vector | ~ 1410

| MDCT in a quantized band of a quantization unit | ~ 1411

index $IND_2$

## Fig.14

index $IND_2(IND_{21})$

1501

vector inverse quantizer

1502

code vector

code book

reproduced sub-vector — 1503

inversely quantized MDCT — 1504

## Fig.15

701

| first sub-quantization unit (low band) index inverse quantization |

704

| second sub-quantization unit index inverse quantization |

702

| first sub-quantization unit (intermediate band) index inverse quantization |

| third sub-quantization unit index inverse quantization |

| first sub-quantization unit (high band) index inverse quantization |

705

703

# Fig.16

from inverse
quantization unit 106

1301

1302

outline inverse
quantization unit → envelope characteristic
inverse normalization unit

index $IND_{13}$

to band amplitude inverse
normalization unit 1201

# Fig.17

transmission of outline pattern
(compression)

frequency

LSP          LSP

quantization of LSP (Line Spectrum Pair)
(apply to code)

44

## Fig.18

```
            │
   ┌─────────────────────────┐
   │  first normalization unit│ ～ 1801
   └─────────────────────────┘
            │
   ┌─────────────────────────┐
   │first sub-quantization unit│ ～ 1802
   └─────────────────────────┘
            │
   ┌──────────────────────────────────┐
   │ first quantization band selection unit│ ～ 1803
   └──────────────────────────────────┘
            │
   ┌─────────────────────────┐
   │ second normalization unit│ ～ 1804
   └─────────────────────────┘
            │
   ┌─────────────────────────┐
   │second sub-quantization unit│ ～ 1805
   └─────────────────────────┘
            │
   ┌──────────────────────────────────┐
   │second quantization band selection unit│ ～ 1806
   └──────────────────────────────────┘
            │
   ┌─────────────────────────┐
   │  third normalization unit│ ～ 1807
   └─────────────────────────┘
            │
   ┌─────────────────────────┐
   │third sub-quantization unit│ ～ 1808
   └─────────────────────────┘
            │
   ┌──────────────────────────────────┐
   │ third quantization band selection unit│ ～ 1809
   └──────────────────────────────────┘
```

Fig.19(a)

time

transformation to data
on frequency axis
(MDCT or FFT)

Fig.19(b)

frequency

outline extraction

Fig.19(c)

frequency

Fig.19(d)

normalization

frequency

division into bands, and
quantization
(search for the nearest code)

Fig.19(e)

x

y

z

46

## Fig.20(a)

quantized output = A ( x + y + z )

| normalization  A |
|---|

| quantization x |
|---|

| quantization y |
|---|

| quantization z |
|---|

## Fig.20(b)

quantized output = $\alpha x + \beta y + \gamma z$

A | B | C

| normalization $\alpha$ |
|---|

| quantization x |
|---|

| normalization $\beta$ |
|---|

| quantization y |
|---|

| normalization $\gamma$ |
|---|

| quantization z |
|---|

## Fig.20(c)

quantized output = $\alpha x + \beta y + \gamma z$

A

| normalization $\alpha$ |
|---|

| quantization x |
|---|

B

| normalization $\beta$ |
|---|

| quantization y |
|---|

C

| normalization $\gamma$ |
|---|

| quantization z |
|---|

# Fig.21

amplitude

quantized output = $\alpha x + \beta y + \gamma z$

frequency

division of frequency ➝ extraction of outline from each frequency (normalization) ➝ search for pattern

$\alpha$

$\beta$

$\gamma$

x

y

z

EP 0 919 989 A1

# Fig.22

Fig.23(a)

```
┌──────────────┐
│  inverse     │
│ quantization x'│
└──────────────┘
        ┌──────────────┐
        │  inverse     │
        │ quantization y'│
        └──────────────┘
                ┌──────────────┐
                │  inverse     │
                │ quantization z'│
                └──────────────┘
┌──────────────────────────────────────────┐
│          inverse normalization A'          │
└──────────────────────────────────────────┘
```

Fig.23(b)

```
        A              B              C
┌──────────────┐
│  inverse     │
│ quantization x'│
└──────────────┘
┌──────────────┐
│  inverse     │
│ normalization α'│
└──────────────┘
        ┌──────────────┐
        │  inverse     │
        │ quantization y'│
        └──────────────┘
        ┌──────────────┐
        │  inverse     │
        │ normalization β'│
        └──────────────┘
                ┌──────────────┐
                │  inverse     │
                │ quantization z'│
                └──────────────┘
                ┌──────────────┐
                │  inverse     │
                │ normalization γ'│
                └──────────────┘
```

Fig.23(c)

```
        A
┌──────────────┐
│  inverse     │
│ quantization x'│
└──────────────┘
┌──────────────┐
│  inverse     │
│ normalization α'│
└──────────────┘
            B
        ┌──────────────┐
        │  inverse     │
        │ quantization y'│
        └──────────────┘
        ┌──────────────┐
        │  inverse     │
        │ normalization β'│
        └──────────────┘
                    C
                ┌──────────────┐
                │  inverse     │
                │ quantization z'│
                └──────────────┘
                ┌──────────────┐
                │  inverse     │
                │ normalization γ'│
                └──────────────┘
```

Fig.24

```
                                                    1603
                  1601                                 ⌐
            ┌──────────┐              ┌──────────────────────┐
        ────│   FFT    │          ────│ Division into sub-bands │
            └──────────┘              └──────────────────────┘
                  1602                             1604
                  (adaptive bit                    (scale factor
                   allocation unit)                 normalization unit)
        ┌─────────────────────┐      ┌──────────────────────┐
        │ Calculation of adaptive │      │    Normalization by     │
        │ bit allocation by calculating │  │ scale factor to each band │──────▶ index IND₁
        │ minimum audible limit and │     └──────────────────────┘
        │ masking characteristic │                    1605
        └─────────────────────┘      ┌──────────────────────┐
                  │          └────────▶│  scalar quantization   │──────▶ index IND₂
                  ▼                    └──────────────────────┘
               index
```

## INTERNATIONAL SEARCH REPORT

| | International application No. |
|---|---|
| | PCT/JP98/02135 |

**A. CLASSIFICATION OF SUBJECT MATTER**
Int.Cl$^6$ G10L9/18, H03M7/30

According to International Patent Classification (IPC) or to both national classification and IPC

**B. FIELDS SEARCHED**

Minimum documentation searched (classification system followed by classification symbols)
Int.Cl$^6$ G10L9/18, G10L7/04, H03M7/30

Documentation searched other than minimum documentation to the extent that such documents are included in the fields searched
Jitsuyo Shinan Koho        1926–1996
Toroku Jitsuyo Shinan Koho    1994–1998

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP, 06-077840, A (Fujitsu Ltd.), 18 March, 1994 (18. 03. 94) (Family: none) | 1-38 |
| A | JP, 06-169449, A (Mitsubishi Electric Corp.), 14 June, 1994 (14. 06. 94) (Family: none) | 1-38 |
| A | JP, 09-034499, A (Kokusai Electric Co., Ltd.), 7 February, 1997 (07. 02. 97) (Family: none) | 1-38 |
| A | JP, 05-165499, A (Oki Electric Industry Co., Ltd.), 2 July, 1993 (02. 07. 93) (Family: none) | 1-38 |
| A | JP, 04-171500, A (NEC Corp.), 18 June, 1992 (18. 06. 92) (Family: none) | 1-38 |
| A | JP, 03-228433, A (Fujitsu Ltd.), 9 October, 1991 (09. 10. 91) (Family: none) | 1-38 |
| EA | JP, 09-130260, A (Victor Co. of Japan, Ltd.), 16 May, 1997 (16. 05. 97) (Family: none) | 1-38 |

[x] Further documents are listed in the continuation of Box C.   [ ] See patent family annex.

| | |
|---|---|
| * Special categories of cited documents:<br>"A" document defining the general state of the art which is not considered to be of particular relevance<br>"E" earlier document but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 9 September, 1998 (09. 09. 98) | 22 September, 1998 (22. 09. 98) |

| Name and mailing address of the ISA/<br>Japanese Patent Office | Authorized officer |
|---|---|
| Facsimile No. | Telephone No. |

Form PCT/ISA/210 (second sheet) (July 1992)

**INTERNATIONAL SEARCH REPORT**

| International application No. |
| --- |
| PCT/JP98/02135 |

C (Continuation).   DOCUMENTS CONSIDERED TO BE RELEVANT

| Category* | Citation of document, with indication, where appropriate, of the relevant passages | Relevant to claim No. |
| --- | --- | --- |
| EA | JP, 09-127987, A  (Sony Corp.),<br>16 May, 1997 (16. 05. 97)  (Family: none) | 1-38 |
| EA | JP, 09-281995, A  (NEC Corp.),<br>31 October, 1997 (31. 10. 97)  (Family: none) | 1-38 |
| EA | JP, 10-020898, A  (Matsushita Electric Industrial Co., Ltd.),<br>23 January, 1998 (23. 01. 98)  (Family: none) | 1-38 |

Form PCT/ISA/210 (continuation of second sheet) (July 1992)